# EUROPEAN PATENT APPLICATION

(11) **EP 4 672 325 A1**
(43) Date of publication of application: **31.12.2025**
(21) Application number: 24900353.4
(22) Date of filing: 06.11.2024
(51) Int. Cl.: H01L 23/373, B22F 1/05, B22F 1/16, C01B 32/21, C04B 35/628

(54) **COMPOSITE FILLER AND METHOD FOR PRODUCING SAME**

(30) Priority: 07.12.2023 JP 2023206607
(71) Applicant: Nippon Aerosil Co., Ltd., Shinjuku-ku Tokyo 163-0913 (JP)
(72) Inventor: TASHIRO, Hideaki, Yokkaichi-shi, Mie 510-0841 (JP); AOKI, Masao, Yokkaichi-shi, Mie 510-0841 (JP)
(74) Representative: Gille Hrabal Partnerschaftsgesellschaft mbB Patentanwälte
(86) International application number: PCT/JP2024/039394
(87) International publication number: WO 2025/121058

(57) **Abstract**

There is provided a composite filler that has heat dissipation (a thermal conduction property) and higher electrical insulation than conventional electrical insulation. The composite filler is a composite filler forming a core-shell structure composed of a core substance made of carbon, metal, zinc oxide or zirconium oxide and a shell substance attached to a surface of the core substance. The shell substance is formed from fumed oxide particles, the fumed oxide particles being attached to a part or a whole of the surface of the core substance by mixing of the fumed oxide particles and the core substance in a dry ball mill. The fumed oxide particles are particles changed from bulky aggregated particles to gathered bulk particles, the aggregated particles being formed from perfect sphere primary particles aggregating in a form of strings of beads and fusing together. In the composite filler, percentage of the core substance ranges from 30 vol% to 85 vol% and percentage of the shell substance ranges from 15 vol% to 70 vol%, a thermal conductivity is 0.075 W/m·K or more, a volume resistivity is 1.0×10⁵ Ω·cm or more, and a dielectric breakdown voltage is 1 kV/mm or more.

## Description

### {Technical Field}

The presently disclosed subject matter relates to a composite filler including a core with heat dissipation and a shell with electrical insulation attached to a surface of the core, and a method for producing the same.

### {Background Art}

Electronic devices used in electric vehicles or the like are increasing in voltage and current in these years. This entails increase in the amount of heat from such an electronic device, and how to dissipate heat is one of major issues. Parts used in this electronic device are required to have high radiation performance, i.e., a high thermal conduction property and are also required to have high electrical insulation in terms of reliability.

There have been disclosed thermally conductive particles, including a composite core and an insulating material coating at least part of the composite core, as a material with a thermal conduction property and electrical insulation, and manufacture thereof (see, for example, Patent Literature 1 (claims 1 and 13, and paragraphs [0021], [0028], [0037], [0038], [0049], [0053], [0058], [0097] and [0098]). The thermally conductive particles are mixed with resin to produce a resin composition. The resin composition is molded into an article, and the molded article is used as a part of an electronic device as described above.

The above-described composite core includes a plurality of core particles with a thermal conduction property and an organic binder binding the core particles together. The core particles are selected from the group consisting of metal particles, ceramic particles, carbon-based particles, and mixtures of these. The insulating material is selected from the group consisting of aluminum oxide (alumina), zinc oxide, talc, magnesium oxide, silicon dioxide, boehmite, boron nitride, mica, aluminum nitride, silicon nitride, zinc sulfide, sericite, and mixtures of these.

A production method for the above-described thermally conductive particles is a method that, after mixing the plurality of core particles and the organic binder by compression shear mixing, and binding and mixing the core particles to the organic binder to form the composite core, mixes the composite core with the insulating material by compression shear mixing and at least partially coats the composite core with the insulating material.

Metal particles for the core particles include copper, silver, nickel, aluminum, or alloys of these, and carbon-based particles for the core particles include black lead, carbon nanotubes, fullerene, graphene, carbon black, glass carbon, carbon fibers, amorphous carbon, boron carbide, or mixtures of these.

The above-described thermally conductive particles made in the above-described manner exhibit a volume resistivity, when measured on a cylinder of the thermally conductive particles having a 10 mm diameter and a height of 3.0 mm at an applied voltage of 500 V, which ranges at least from 1×10⁴ Ω·cm to 1×10¹⁰ Ω·cm.

### {Citation List}

### {Patent Literature}

Patent Literature 1: JP 2017-504177 A

### {Summary of Invention}

### {Technical Problem}

Thermally conductive particles in Patent Literature 1 have a volume resistivity, when measured at 500 V that is an indicator of insulation, which ranges from 1×10⁴ Ω·cm to 1×10¹⁰ Ω·cm. However, the thermally conductive particles do not suffice as a material for or a part of an electronic device increased in voltage and current in terms of electrical insulation, and there is a need for a material with higher electrical insulation.

The presently disclosed subject matter has as its object to provide a composite filler with heat dissipation (a thermal conduction property) and higher electrical insulation than conventional electrical insulation, and a method for producing the same.

### {Solution to Problem}

A first aspect of the presently disclosed subject matter is a composite filler forming a core-shell structure composed of a core substance made of carbon, metal, zinc oxide or zirconium oxide and a shell substance attached to a surface of the core substance, wherein the shell substance is formed from fumed oxide particles, the fumed oxide particles being attached to a part or a whole of the surface of the core substance by mixing of the fumed oxide particles and the core substance in a dry ball mill, the fumed oxide particles are particles changed from bulky aggregated particles to gathered bulk particles, the aggregated particles being formed from perfect sphere primary particles aggregating in a form of strings of beads and fusing together, percentage of the core substance ranges from 30 vol% to 85 vol% and percentage of the shell substance ranges from 15 vol% to 70 vol% when percentage of the composite filler is defined as 100 vol%, a thermal conductivity measured using a thermal conductivity measurement device "TRIDENT" (manufactured by C-Therm Technologies Ltd.) and a compression test accessory (CTA) under a maximum compressive load condition (2400.0 gf) is equal to or more than 0.075 W/m·K, a volume resistivity measured using a high resistance resistivity meter "Hiresta-UX" (manufactured by Mitsubishi Chemical Analytech Co., Ltd.: model number "MCP-HT800") or a low resistance resistivity meter "Loresta-GX" (manufactured by Mitsubishi Chemical Analytech Co., Ltd.: model number "MCP-T700") and a powder resistance measurement system (manufactured by Mitsubishi Chemical Analytech Co., Ltd.: model number "MCP-PD-51") is equal to or more than 1.0×10⁵ Ω·cm, and a dielectric breakdown voltage measured using an AC withstand voltage tester 7473 (manufactured by Keisoku Giken Co., Ltd.) is equal to or more than 1 kV/mm.

A second aspect of the presently disclosed subject matter is an invention based on the first aspect, wherein the carbon serving as the core substance is black lead, Ketchenblack, graphite, or carbon black, and the metal serving as the core substance is copper, zinc, tin, nickel, aluminum, or stainless steel.

A third aspect of the presently disclosed subject matter is an invention based on the first aspect, wherein a particle diameter of the composite filler is a particle diameter when a volume distribution of the composite filler is measured using a laser diffraction/scattering particle diameter distribution measurement device (manufactured by HORIBA, Ltd.: model "LA960") and ranges from 1 µm to 300 µm.

A fourth aspect of the presently disclosed subject matter is an invention based on the first aspect, wherein the fumed oxide particles are fumed silica particles or fumed alumina particles.

A fifth aspect of the presently disclosed subject matter is a method for producing a composite including mixing of fumed oxide particles and a core substance made of carbon, metal, zinc oxide or zirconium oxide at a volume ratio between the fumed oxide particles and the core substance of 30 to 85:70 to 15 in a dry ball mill, the fumed oxide particles being changed from bulky aggregated particles to gathered bulk particles, the aggregated particles being formed from perfect sphere primary particles aggregating in a form of strings of beads and fusing together to form a core-shell structure in which the fumed oxide particles are attached as a shell substance to a part or a whole of a surface of the core substance, wherein the fumed oxide particles are particles changed from the bulky aggregated particles to the gathered bulk particles, the aggregated particles being formed from the perfect sphere primary particles aggregating in a form of strings of beads and fusing together to aggregate bulkily.

### {Advantageous Effects of Invention}

In the composite filler according to the first aspect of the presently disclosed subject matter, the shell substance composed of particles changed from bulky aggregated particles to gathered bulk particles, the aggregated particles being formed from perfect sphere primary particles aggregating in a form of strings of beads and fusing together, is attached to the surface of the core substance made of carbon, metal, zinc oxide or zirconium oxide by being mixed in the dry ball mill. When the percentage of the composite filler is defined as 100 vol%, the percentage of the core substance ranges from 30 vol% to 85 vol%, and the percentage of the shell substance ranges from 15 vol% to 70 vol%. Therefore, the composite filler has a thermal conductivity equal to or more than 0.075 W/m·K, a volume resistivity equal to or more than 1.0×10⁵ Ω·cm, and a dielectric breakdown voltage equal to or more than 1 kV/mm.

In the composite filler according to the second aspect, the carbon serving as the core substance is black lead, Ketchenblack, graphite, or carbon black, and the metal serving as the core substance is copper, zinc, tin, nickel, aluminum, or stainless steel. The composite filler thus has a high thermal conduction property.

The composite filler according to the third aspect has a particle diameter which ranges from 1 µm to 300 µm. Therefore, when the composite filler is mixed with resin to produce a resin composition, the resin composition can be easily molded.

In the composite filler according to the fourth aspect of the presently disclosed subject matter, the fumed oxide particles are fumed silica particles or fumed alumina particles. Therefore, when the fumed oxide particles are attached as the shell substance to the surface of the core substance, the fumed oxide particles increase electrical insulation of the composite filler.

The production method for the composite filler according to the fifth aspect of the presently disclosed subject matter mixes the fumed oxide particles changed from bulky aggregated particles, formed from perfect sphere primary particles aggregating in a form of strings of beads and fusing together, to gathered bulk particles and the core substance made of carbon, metal, zinc oxide or zirconium oxide at the volume ratio between the fumed oxide particles and the core substance of 30 to 85:70 to 15 in the dry ball mill to produce the composite filler. Thus, the fumed oxide particles are attached as the shell substance to the surface of the core substance in a relatively easy manner. The composite filler produced by the production method has heat dissipation (a thermal conduction property) and higher electrical insulation than conventional electrical insulation.

### {Brief Description of Drawings}

Figure 1 is a schematic sectional view of a composite filler in which fumed oxide particles changed from bulky aggregated particles to gathered bulk particles, the aggregated particles being formed from perfect sphere primary particles aggregating in the form of strings of beads and fusing together, are attached to a surface of a core substance according to an embodiment of the presently disclosed subject matter;
Figure 2 is a view illustrating a state in which perfect sphere primary particles aggregate in the form of strings of beads and fuse together to form bulky aggregated particles and the aggregated particles change into the gathered bulk particles illustrated in Figure 1;
Figure 3 is a scanning electron microscope (SEM) photograph illustrating aggregated particles in a smallest particle form in which primary particles of silica are sintered;
Figure 4 is scanning electron microscope (SEM) photograph illustrating gathered bulk particles in which the aggregated particles illustrated in Figure 3 are gathered together;
Figure 5a is a graph in which a particle size distribution curve of Sn powder and a particle size distribution curve of a composite filler formed by mixing the Sn powder and fumed alumina particles in a dry ball mill are plotted on top of each other according to Example 1;
Figure 5b is a scanning electron microscope (SEM) photograph of the Sn powder according to Example 1;
Figure 5c is a scanning electron microscope (SEM) photograph of the composite filler according to Example 1;
Figure 6a is a graph in which a particle size distribution curve of Zn powder and a particle size distribution curve of a composite filler formed by mixing the Zn powder and fumed alumina particles in a dry ball mill are plotted on top of each other according to Example 2;
Figure 6b is a scanning electron microscope (SEM) photograph of the Zn powder according to Example 2;
Figure 6c is a scanning electron microscope (SEM) photograph of the composite filler according to Example 2;
Figure 7a is a graph in which a particle size distribution curve of Ni powder and a particle size distribution curve of a composite filler formed by mixing the Ni powder and fumed alumina particles in a dry ball mill are plotted on top of each other according to Example 3;
Figure 7b is a scanning electron microscope (SEM) photograph of the Ni powder according to Example 3;
Figure 7c is a scanning electron microscope (SEM) photograph of the composite filler according to Example 3;
Figure 8a is a graph in which a particle size distribution curve of SUS powder and a particle size distribution curve of a composite filler formed by mixing the SUS powder and fumed alumina particles in a dry ball mill are plotted on top of each other according to Example 4;
Figure 8b is a scanning electron microscope (SEM) photograph of the SUS powder according to Example 4;
Figure 8c is a scanning electron microscope (SEM) photograph of the composite filler according to Example 4;
Figure 9a is a graph in which a particle size distribution curve of ZnO powder and a particle size distribution curve of a composite filler formed by mixing the ZnO powder and fumed alumina particles in a dry ball mill are plotted on top of each other according to Example 5;
Figure 9b is a scanning electron microscope (SEM) photograph of the ZnO powder according to Example 5;
Figure 9c is a scanning electron microscope (SEM) photograph of the composite filler according to Example 5;
Figure 10a is a graph in which a particle size distribution curve of Cu powder and a particle size distribution curve of a composite filler formed by mixing the Cu powder and fumed alumina particles in a dry ball mill are plotted on top of each other according to Example 6;
Figure 10b is a scanning electron microscope (SEM) photograph of the Cu powder according to Example 6;
Figure 10c is a scanning electron microscope (SEM) photograph of the composite filler according to Example 6;
Figure 11a is a graph in which a particle size distribution curve of Cu powder and a particle size distribution curve of a composite filler formed by mixing the Cu powder and fumed alumina particles in a dry ball mill are plotted on top of each other according to Example 7;
Figure 11b is a scanning electron microscope (SEM) photograph of the Cu powder according to Example 7;
Figure 11c is a scanning electron microscope (SEM) photograph of the composite filler according to Example 7;
Figure 12a is a graph in which a particle size distribution curve of Cu powder and a particle size distribution curve of a composite filler formed by mixing the Cu powder and fumed alumina particles in a dry ball mill are plotted on top of each other according to Example 8;
Figure 12b is a scanning electron microscope (SEM) photograph of the Cu powder according to Example 8;
Figure 12c is a scanning electron microscope (SEM) photograph of the composite filler according to Example 8;
Figure 13a is a graph in which a particle size distribution curve of Cu powder and a particle size distribution curve of a composite filler formed by mixing the Cu powder and fumed alumina particles in a dry ball mill are plotted on top of each other according to Example 9;
Figure 13b is a scanning electron microscope (SEM) photograph of the Cu powder according to Example 9;
Figure 13c is a scanning electron microscope (SEM) photograph of the composite filler according to Example 9;
Figure 14a is a graph in which a particle size distribution curve of Cu powder and a particle size distribution curve of a composite filler formed by mixing the Cu powder and fumed alumina particles in a dry ball mill and then giving surface treatment are plotted on top of each other according to Example 10;
Figure 14b is a scanning electron microscope (SEM) photograph of the Cu powder according to Example 10;
Figure 14c is a scanning electron microscope (SEM) photograph of the composite filler according to Example 10;
Figure 15a is a graph in which a particle size distribution curve of Al powder and a particle size distribution curve of a composite filler formed by mixing the Al powder and fumed alumina particles in a dry ball mill are plotted on top of each other according to Example 11;
Figure 15b is a scanning electron microscope (SEM) photograph of the Al powder according to Example 11;
Figure 15c is a scanning electron microscope (SEM) photograph of the composite filler according to Example 11;
Figure 16a is a graph in which a particle size distribution curve of ZrO powder and a particle size distribution curve of a composite filler formed by mixing the ZrO powder and fumed alumina particles in a dry ball mill are plotted on top of each other according to Example 12;
Figure 16b is a scanning electron microscope (SEM) photograph of the ZrO powder according to Example 12;
Figure 16c is a scanning electron microscope (SEM) photograph of the composite filler according to Example 12;
Figure 17a is a graph in which a particle size distribution curve of black lead powder and a particle size distribution curve of a composite filler formed by mixing the black lead powder and fumed silica particles in a dry ball mill are plotted on top of each other according to Example 13;
Figure 17b is a scanning electron microscope (SEM) photograph of the black lead powder according to Example 13;
Figure 17c is a scanning electron microscope (SEM) photograph of the composite filler according to Example 13;
Figure 18a is a graph in which a particle size distribution curve of Cu powder and a particle size distribution curve of a composite filler formed by dryly mixing the Cu powder and fumed silica particles by hand are plotted on top of each other according to Comparative Example 1;
Figure 18b is a scanning electron microscope (SEM) photograph of the Cu powder according to Comparative Example 1;
Figure 18c is a scanning electron microscope (SEM) photograph of the composite filler according to Comparative Example 1;
Figure 19a is a graph in which a particle size distribution curve of Cu powder and a particle size distribution curve of a composite filler formed by mixing the Cu powder and fumed silica particles with a planetary centrifugal mixer are plotted on top of each other according to Comparative Example 2;
Figure 19b is a scanning electron microscope (SEM) photograph of the Cu powder according to Comparative Example 2;
Figure 19c is a scanning electron microscope (SEM) photograph of the composite filler according to Comparative Example 2;
Figure 20a is a graph in which a particle size distribution curve of Cu powder and a particle size distribution curve of a composite filler formed by mixing the Cu powder and fumed alumina particles in a dry ball mill are plotted on top of each other according to Comparative Example 3;
Figure 20b is a scanning electron microscope (SEM) photograph of the Cu powder according to Comparative Example 3;
Figure 20c is a scanning electron microscope (SEM) photograph of the composite filler according to Comparative Example 3;
Figure 21a is a graph in which a particle size distribution curve of Cu powder and a particle size distribution curve of a composite filler formed by mixing the Cu powder and fumed alumina particles in a dry ball mill are plotted on top of each other according to Comparative Example 4;
Figure 21b is a scanning electron microscope (SEM) photograph of the Cu powder according to Comparative Example 4; and
Figure 21c is a scanning electron microscope (SEM) photograph of the composite filler according to Comparative Example 4.

### {Description of Embodiments}

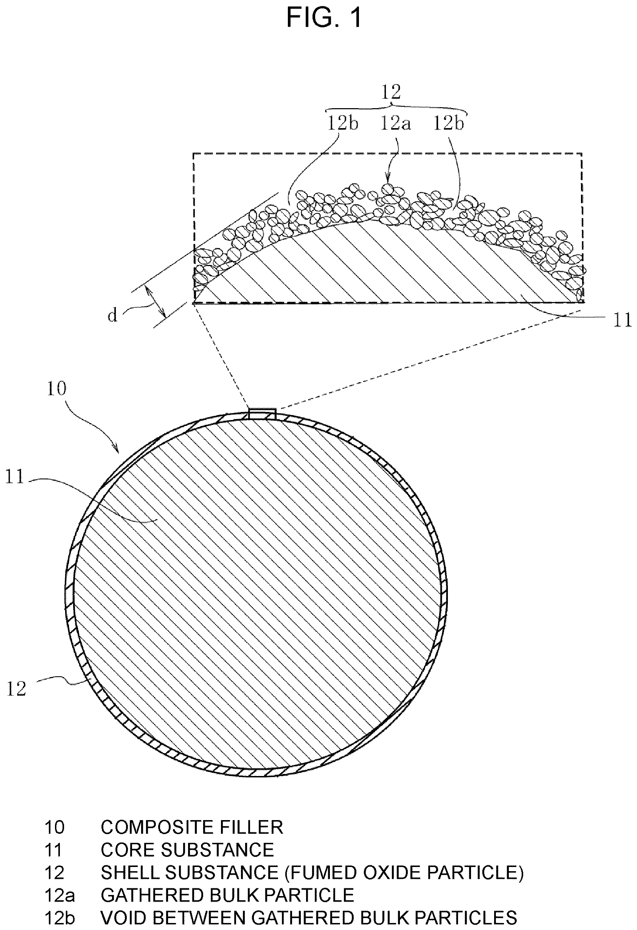

Modes for carrying out the presently disclosed subject matter will be described with reference to the drawings. As illustrated in Figure 1, a composite filler 10 according to the present embodiment forms a core-shell structure composed of a core substance 11 made of carbon, metal, zinc oxide, or zirconium oxide, and a shell substance 12 attached to a surface of the core substance 11. Although the shell substance 12 is attached to a whole of the surface of the core substance 11 in Figure 1, the shell substance 12 may be attached to a part of the surface of the core substance 11. Figure 1 illustrates an example where a shape of the core substance 11 is a spherical shape, but the core substance is not limited to a spherical shape and may have a needle shape, a rod shape, or a flat plate shape.

In a case where the core substance 10 is carbon, an example of carbon is black lead, Ketjenblack, graphite, or carbon black. In a case where the core substance is a metal, an example of the metal is copper, zinc, tin, nickel, aluminum, or stainless steel. Zinc oxide or zirconium oxide is selected as the core substance due to its thermal conductivity as high as those of metals. A particle diameter and a particle size distribution of the core substance differ depending on the material, such as carbon, a metal, zinc oxide, or zirconium oxide, and the production method and cannot be sweepingly determined.

Fumed oxide particles and the core substance are mixed in a dry ball mill at room temperature, and the fumed oxide particles are attached to the surface of the core substance, thereby forming the shell substance 12 according to the present embodiment. An example of the fumed oxide particles is fumed silica particles or fumed alumina particles. The fumed oxide particles include hydrophilic fumed oxide particles and hydrophobic fumed oxide particles. An average primary particle diameter of the fumed oxide particles is measured through image analysis by a transmission electron microscope (TEM), and ranges from 7 nm to 90 nm. In a case where the fumed oxide particles and the core substance are mixed by a dry hand mixing method that is a mixing method other than the dry ball mill or a mixing method using a dry planetary centrifugal mixer, adhesion of the shell substance to the core substance is not sufficient, and a composite filler with a desired thermal conduction property and desired electrical insulation cannot be obtained. As illustrated in the enlarged view in Figure 1, the shell substance 12 is formed to include gathered bulk particles 12a and voids 12b between gathered bulk particles.

In a case where fumed oxide particles and a core substance are mixed in a dry ball mill at room temperature, gathered bulk particles of the fumed oxide particles coat and are attached to the core substance. In addition to this, particles of the core substance itself may decrease in diameter or particles decreased in diameter of the core substance may aggregate. When a particle diameter of a composite filler is checked based on a particle size distribution curve, the number of peak diameters in a particle size distribution may not be limited to one, and a plurality of peak diameters may appear. For this reason, although an average particle diameter of a composite filler cannot be sweepingly determined, it can be seen from particle size distribution curves according to Examples 1 to 13 (to be described later) that particle diameters of composite fillers range from 1 µm to 300 µm. For the same reason as an average particle diameter of a composite filler, an average particle diameter of a shell substance in the composite filler cannot be sweepingly determined. While an average particle diameter of a core substance is in the order of micrometers (µm), an average particle diameter of a shell substance is in the order of nanometers (nm). When thicknesses of shell substance layers which can be estimated from particle size distribution curves are calculated in view of peak diameters of core substances before composition and main peak diameters of composite fillers in Examples 1 to 13 (to be described later), the thicknesses of the shell substance layers range from 3 µm to 20 µm. The thicknesses of the shell substance layers are twice "d" illustrated in Figure 1.

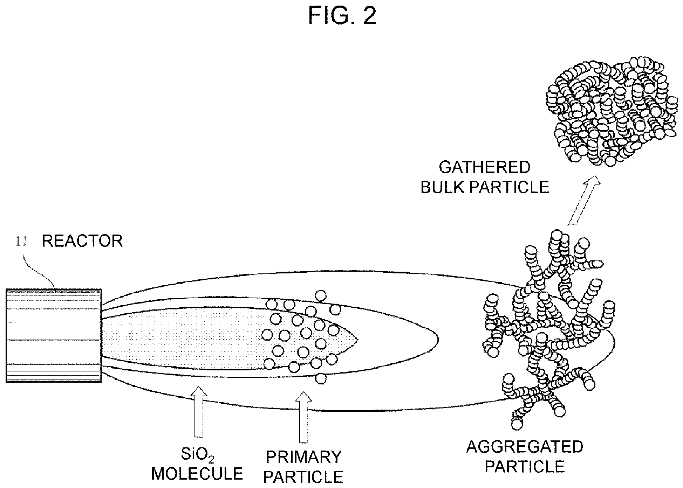

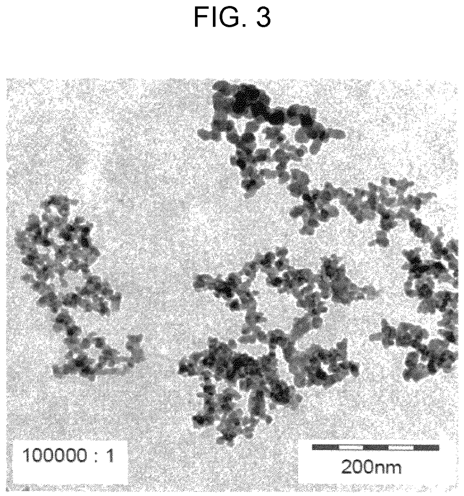

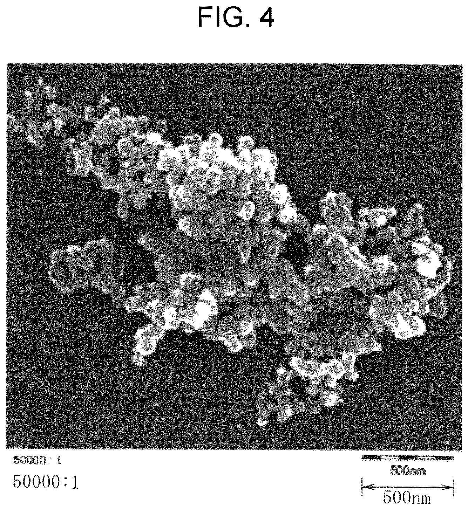

As illustrated in Figure 2, the gathered bulk particles 12a will be described taking as an example a case where fumed oxide particles are fumed silica particles. Mixed gas of SiCl₄, H₂, and O₂ as a vaporizing raw material is injected from a reactor as a burner, aggregated particles in a smallest particle form in which primary particles are sintered are formed, and the aggregated particles gather due to weak interaction, such as hydrogen bonding or van der Waals force, to form gathered bulk particles. In a cluster of composite fillers, gaps between core substances are densely filled with a shell substance, and the shell substance forms a three-dimensional network which densely fills voids between the core substances. As a result, it is possible to make a volume resistivity of the composite fillers as the cluster equal to or higher than 1.0×10⁵ Ω·cm and make a dielectric breakdown voltage equal to or higher than 1 kV/mm without impairing a high thermal conduction property of the core substances. For this reason, high electrical insulation can be achieved while an inherent high thermal conduction property of each core substance is maintained. Aggregated particles in the smallest particle form in which primary particles are sintered are illustrated in Figure 3, and gathered bulk particles formed when aggregated particles gather due to weak interaction, such as hydrogen bonding or van der Waals force, are illustrated in Figure 4.

The percentage of a core substance ranges from 30 vol% to 85 vol%, and the percentage of a shell substance ranges from 15 vol% to 70 vol% when the percentage of a composite filler is defined as 100 vol%. Preferably, the percentage of the core substance ranges from 30 vol% to 70 vol%, and the percentage of the shell substance ranges from 30 vol% to 70 vol%. In a case where the percentage of the core substance is less than 30 vol%, and the percentage of the shell substance exceeds 70 vol%, a composite filler with a desired thermal conduction property can hardly be obtained. In a case where the percentage of the core substance exceeds 85 vol%, and the percentage of the shell substance is less than 15 vol%, a composite filler with desired volume resistivity and a desired dielectric breakdown voltage can hardly be obtained. Since a shell substance formed to include gathered bulk particles 12a composed of fumed oxide particles and voids 12 (see the enlarged view in Figure 1) is mixed in a dry ball mill and is attached to a surface of a core substance at a predetermined vol%, a composite filler according to the present embodiment maintains a high thermal conduction property and has high volume resistivity and a high dielectric breakdown voltage.

The composite filler according to the present embodiment has a thermal conductivity equal to or more than 0.075 W/m·K, preferably equal to or more than 0.100 W/m·K when the thermal conductivity is measured using a thermal conductivity measurement device "TRIDENT" (manufactured by C-Therm Technologies Ltd.) and a compression test accessory (CTA) under a maximum compressive load condition (2,400.0 gf). The composite filler according to the present embodiment has a volume resistivity equal to or more than 1.0×10⁵ Ω·cm, preferably equal to or more than 2.0×10⁵ Ω·cm when the volume resistivity is measured using a high resistance resistivity meter "Hiresta-UX" (manufactured by Mitsubishi Chemical Analytech Co., Ltd.: model number "MCP-HT800") or a low resistance resistivity meter "Loresta-GX" (manufactured by Mitsubishi Chemical Analytech Co., Ltd.: model number "MCP-T700") and a powder resistance measurement system (manufactured by Mitsubishi Chemical Analytech Co., Ltd.: model number "MCP-PD-51"). Further, the composite filler according to the present embodiment has a dielectric breakdown voltage equal to or more than 1 kV/mm, preferably equal to or more than 2 kV/mm when the dielectric breakdown voltage is measured using an AC withstand voltage tester 7473 (manufactured by Keisoku Giken Co., Ltd.).

The above-described thermal conductivity and volume resistivity are values obtained when the composite filler as powder was subjected to measurement. The above-described dielectric breakdown voltage is a value obtained when a resin molded body was subjected to measurement. The resin molded body was made by mixing 63 vol% of a silicone resin (manufactured by Momentive Performance Materials Inc.: model number "YE5822A") as resin, 7 vol% of a curing agent (manufactured by Momentive Performance Materials Inc.: model number "YE5822B"), and 30 vol% of the composite filler to prepare a resin mixture, mixing the resin mixture and the composite filler using a planetary centrifugal mixer (manufactured by THINKY CORPORATION: model number "ARE-310") at 2,000 rpm for 5 minutes to prepare a resin composition, and then putting the resin composition in a mold whose cavity was 15 cm long by 15 cm wide by 2 mm deep and curing the resin by holding the resin composition at a temperature of 130°C under a pressure of 10 MPa (100 kg/cm²) using a heat press (manufactured by Kodaira Seisakusho Co., Ltd.: model number "PY15-EA") for 10 minutes.

### [Examples]

Examples of the presently disclosed subject matter will be described in detail together with comparative examples.

Raw materials used in the examples of the presently disclosed subject matter and the comparative examples are as described below. The following raw materials were used in the same state as they were sold on the open market.
(1) Tin powder (Sn, manufactured by FUJIFILM Wako Pure Chemical Corporation: article number "206-01505")
(2) Hydrophilic fumed alumina particles ((Al₂O₃, manufactured by Evonik Industries AG: article number "AEROXIDE (Japanese registered trademark) Alu C" (average primary particle diameter of 13 nm))
(3) Zinc powder (Zn, manufactured by Hayashi Pure Chemical Ind., Ltd.: article number "26000085")
(4) Nickel powder (Ni, manufactured by FUJIFILM Wako Pure Chemical Corporation: article number "145-00982")
(5) Stainless steel powder (SUS, manufactured by FUJIFILM Wako Pure Chemical Corporation: article number "900919")
(6) Zinc oxide powder (ZnO, manufactured by Hayashi Pure Chemical Ind., Ltd.: article number "26000375")
(7) Copper powder (Cu, manufactured by Hayashi Pure Chemical Ind., Ltd.: article number "03003695")
(8) Hydrophilic fumed alumina particles (Al₂O₃, manufactured by Evonik Industries AG: article number "VP Alu 30" (average primary particle diameter of 90 nm))
(9) Hydrophobic fumed alumina particles (Al₂O₃, manufactured by NIPPON AEROSIL CO., LTD.: article number "VP Alu C RK" (average primary particle diameter of 13 nm))
(10) Isobutyl(trimethoxy)silane (IBTMO, manufactured by Evonik Industries AG: article number "Dynasylan (Japanese registered trademark) IBTMO")
(11) Aluminum powder (Al, manufactured by Hayashi Pure Chemical Ind., Ltd.: article number "01001325")
(12) Zirconium oxide powder (ZrO, manufactured by FUJIFILM Wako Pure Chemical Corporation: article number "264-00485")
(13) Black lead powder (C, manufactured by Ito Graphite Co., Ltd.: article number "SG-BL40")
(14) Hydrophilic fumed silica particles (manufactured by NIPPON AEROSIL CO., LTD.: article number "AEROSIL (Japanese registered trademark) 380S" (average primary particle diameter of 7 nm))

### <Example 1>

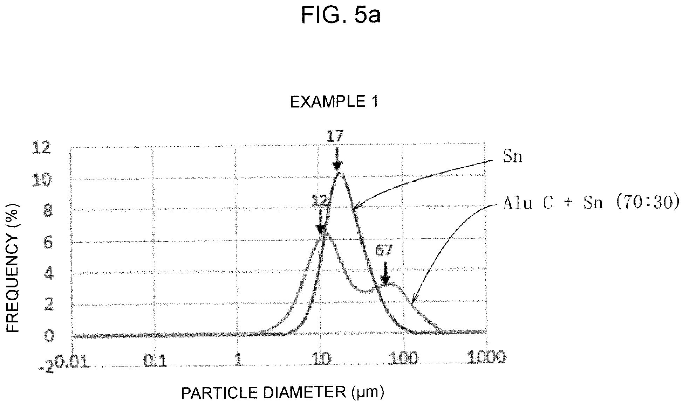

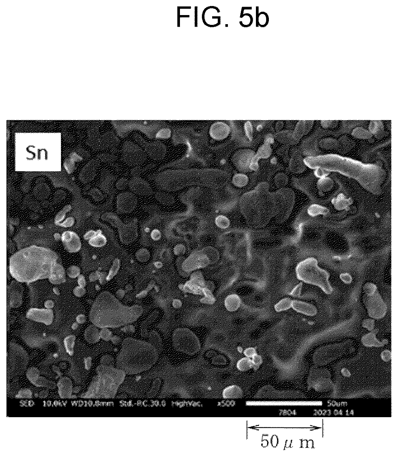

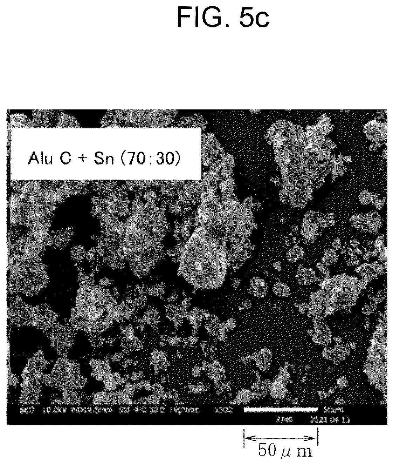

As a core substance, Sn (tin) powder was prepared. The Sn powder had one peak particle diameter of 17 µm in a particle size distribution as illustrated in Figure 5a, and a particle diameter for which a cumulative volume calculated from a small diameter side was 10% was 9.6 µm, a particle diameter for which a cumulative volume was 50% was 18.4 µm, and a particle diameter for which a cumulative volume was 90% was 40.6 µm, as illustrated in Table 1. As a shell substance, hydrophilic fumed alumina particles (an article number "AEROXIDE (Japanese registered trademark) Alu C") were prepared. Then, 30 vol% of the core substance (Sn powder) and 70 vol% of the shell substance (fumed alumina particles) were dryly mixed in a pot mill with 5-mm-diameter alumina balls manufactured by NIKKATO CORPORATION while the pot mill was rotated at room temperature in the atmosphere at a speed of 110 rpm for 5 hours by a ball mill rotating table (manufactured by MASUDA CORPORATION: model number "UNIVERSAL BALL MILL MODEL UBM-S") to obtain a composite filler. A particle diameter distribution of the composite filler had two peaks at a particle diameter of 12 µm and a particle diameter of 67 µm, as illustrated in Figure 5a. As illustrated in Table 1, in the particle diameter distribution of the composite filler, a particle diameter for which a cumulative volume calculated from a small diameter side was 10% was 5.9 µm, a particle diameter for which a cumulative volume was 50% was 15.7 µm, and a particle diameter for which a cumulative volume was 90% was 89.3 µm. Since particle diameters in the particle size distribution of the Sn powder covered a wide range from 4 µm to 150 µm, a thickness of a shell substance layer was difficult to calculate. Figure 5b illustrates a scanning electron microscope (SEM) photograph of the Sn powder, and Figure 5c illustrates a scanning electron microscope (SEM) photograph of the composite filler.

**[Table 1]**

| | Sn | Alu C+Sn |
|---|---|---|
| 10% diameter on volumetric basis | 9.6 µm | 5.9 µm |
| 50% diameter on volumetric basis | 18.4 µm | 15.7 µm |
| 90% diameter on volumetric basis | 40.6 µm | 89.3 µm |

A particle diameter of a core substance or a composite filler according to each of Example 1 and other examples and comparative examples to be described below is a particle diameter in a particle size distribution curve where the horizontal axis represents a particle diameter of a core substance or a composite filler obtained through measurement using a laser diffraction/scattering particle diameter distribution measurement device (manufactured by HORIBA, Ltd.: model "LA960") and the vertical axis represents the frequency of particles in terms of volume. An average primary particle diameter of a shell substance is a particle diameter measured through image analysis by a transmission electron microscope (TEM).

### <Example 2>

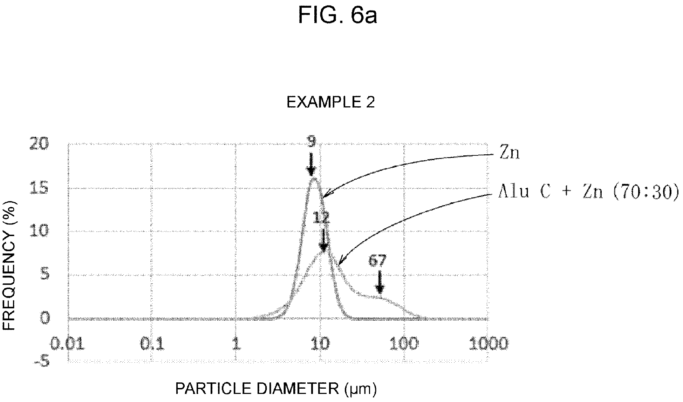

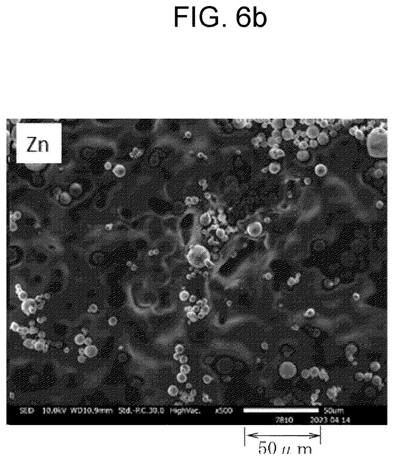

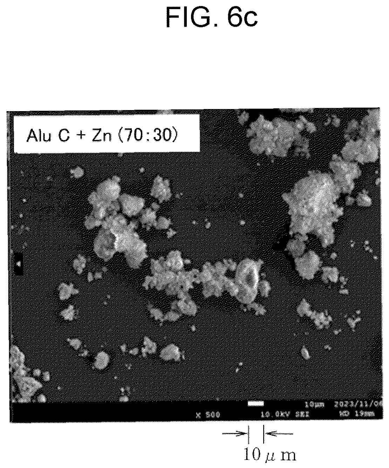

As a core substance, Zn (zinc) powder was prepared. The Zn powder had one peak particle diameter of 9 µm in a particle size distribution as illustrated in Figure 6a, and a particle diameter for which a cumulative volume calculated from a small diameter side was 10% was 5.2 µm, a particle diameter for which a cumulative volume was 50% was 8.0 µm, and a particle diameter for which a cumulative volume was 90% was 12.2 µm, as illustrated in Table 2. As a shell substance, hydrophilic fumed alumina particles (article number "AEROXIDE (Japanese registered trademark) Alu C") which were the same as in Example 1 were prepared. Then, 30 vol% of the core substance (Zn powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 12 µm and a particle diameter of 67 µm, as illustrated in Figure 6a. As illustrated in Table 2, in the particle diameter distribution of the composite filler, a particle diameter for which a cumulative volume calculated from a small diameter side was 10% was 5.1 µm, a particle diameter for which a cumulative volume was 50% was 12.2 µm, and a particle diameter for which a cumulative volume was 90% was 50.4 µm. Since particle diameters in the particle size distribution of the Zn powder covered a relatively narrow range from 3 µm to 22 µm, a thickness of a shell substance layer was estimated to be 12 µm-9 µm = 3 µm. Figure 6b illustrates a scanning electron microscope (SEM) photograph of the Zn powder, and Figure 6c illustrates a scanning electron microscope (SEM) photograph of the composite filler.

**[Table 2]**

| | Zn | Alu C+Zn |
|---|---|---|
| 10% diameter on volumetric basis | 5.2 µm | 5.1 µm |
| 50% diameter on volumetric basis | 8.0 µm | 12.2 µm |
| 90% diameter on volumetric basis | 12.2 µm | 50.4 µm |

### <Example 3>

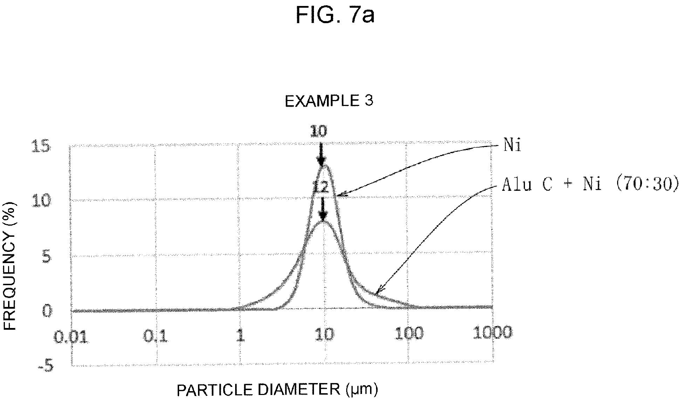

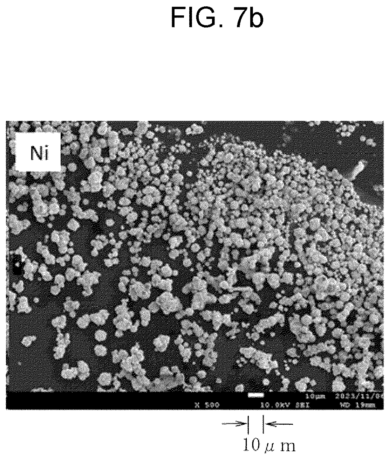

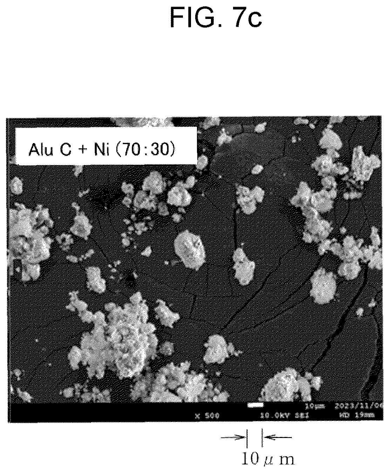

As a core substance, Ni (nickel) powder was prepared. The Ni powder had one peak particle diameter of 10 µm in a particle size distribution as illustrated in Figure 7a, and a particle diameter for which a cumulative volume calculated from a small diameter side was 10% was 5.6 µm, a particle diameter for which a cumulative volume was 50% was 9.6 µm, and a particle diameter for which a cumulative volume was 90% was 16.5 µm, as illustrated in Table 3. As a shell substance, hydrophilic fumed alumina particles (article number "AEROXIDE (Japanese registered trademark) Alu C") which were the same as in Example 1 were prepared. Then, 30 vol% of the core substance (Ni powder) and 70 vol% of the shell substance (fumed alumina particles) were dryly mixed using the same dry ball mill as Example 1 by the same method as Example 1 to obtain a composite filler. A particle diameter distribution of the composite filler had one peak at a particle diameter of 12 µm, as illustrated in Figure 7a. As illustrated in Table 3, in the particle diameter distribution of the composite filler, a particle diameter for which a cumulative volume calculated from a small diameter side was 10% was 3.3 µm, a particle diameter for which a cumulative volume was 50% was 9.2 µm, and a particle diameter for which a cumulative volume was 90% was 38.4 µm. Since particle diameters in the particle size distribution of the Ni powder covered a relatively narrow range from 3 µm to 30 µm, a thickness of a shell substance layer was estimated to be 12 µm-10 µm = 2 µm. Figure 7b illustrates a scanning electron microscope (SEM) photograph of the Ni powder, and Figure 7c illustrates a scanning electron microscope (SEM) photograph of the composite filler.

**[Table 3]**

| | Ni | Alu C+Ni |
|---|---|---|
| 10% diameter on volumetric basis | 5.6 µm | 3.3 µm |
| 50% diameter on volumetric basis | 9.6 µm | 9.2 µm |
| 90% diameter on volumetric basis | 16.5 µm | 38.4 µm |

### <Example 4>

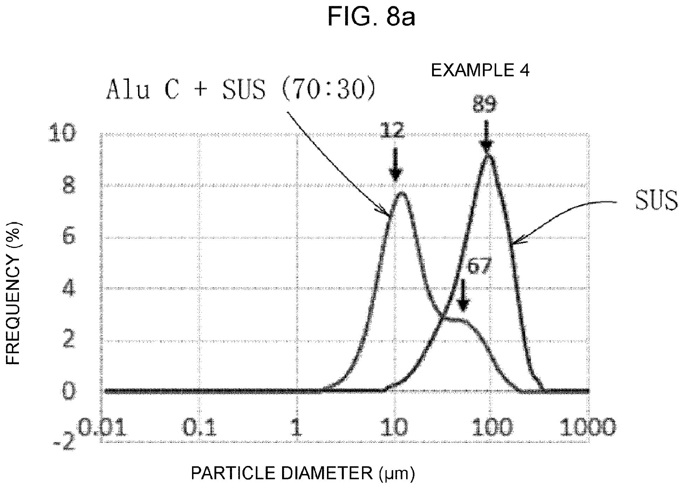

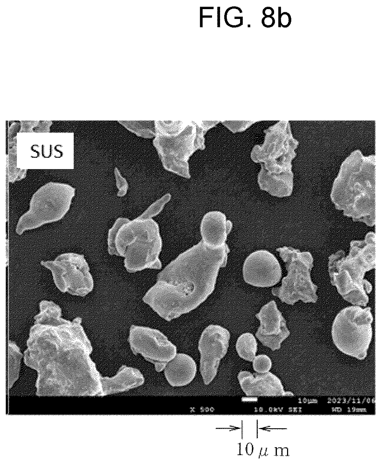

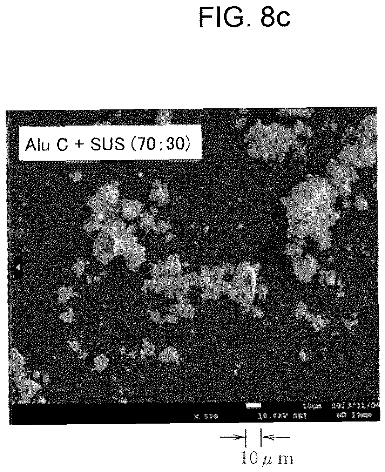

As a core substance, SUS (stainless steel) powder was prepared. The SUS powder had one peak particle diameter of 89 µm in a particle size distribution as illustrated in Figure 8a, and a particle diameter for which a cumulative volume calculated from a small diameter side was 10% was 26.0 µm, a particle diameter for which a cumulative volume was 50% was 68.9 µm, and a particle diameter for which a cumulative volume was 90% was 160.3 µm, as illustrated in Table 4. As a shell substance, hydrophilic fumed alumina particles (article number "AEROXIDE (Japanese registered trademark) Alu C") which were the same as in Example 1 were prepared. Then, 30 vol% of the core substance (SUS powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 12 µm and a particle diameter of 67 µm, as illustrated in Figure 8a. As illustrated in Table 4, in the particle diameter distribution of the composite filler, a particle diameter for which a cumulative volume calculated from a small diameter side was 10% was 5.8 µm, a particle diameter for which a cumulative volume was 50% was 13.4 µm, and a particle diameter for which a cumulative volume was 90% was 57.6 µm. Since particle diameters in the particle size distribution of the SUS powder covered a wide range from 8 µm to 300 µm, a thickness of a shell substance layer was difficult to calculate. Figure 8b illustrates a scanning electron microscope (SEM) photograph of the SUS powder, and Figure 8c illustrates a scanning electron microscope (SEM) photograph of the composite filler.

**[Table 4]**

| | SUS | Alu C+SUS |
|---|---|---|
| 10% diameter on volumetric basis | 26.0 µm | 5.8 µm |
| 50% diameter on volumetric basis | 68.9 µm | 13.4 µm |
| 90% diameter on volumetric basis | 160.3 µm | 57.6 µm |

### <Example 5>

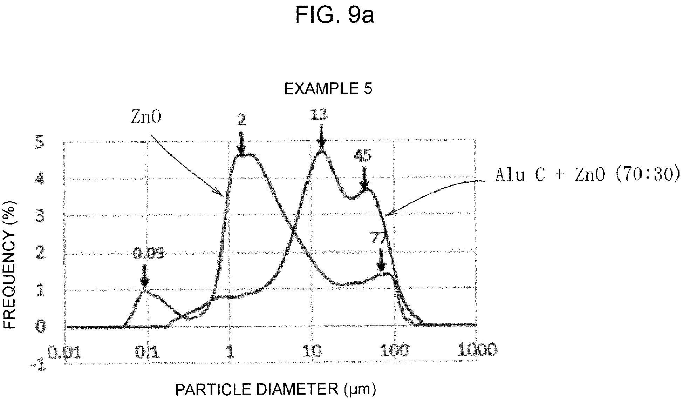

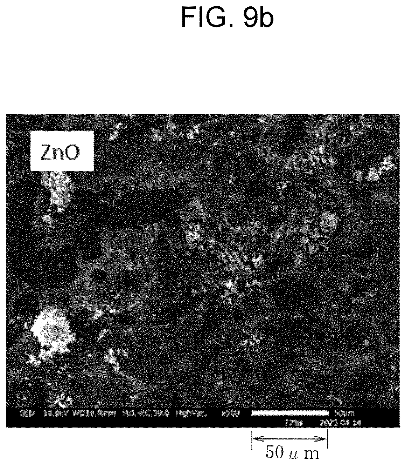

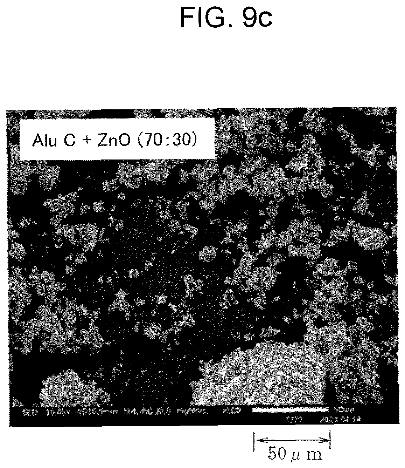

As a core substance, ZnO (zinc oxide) powder was prepared. The ZnO powder had three peak particle diameters of 0.09 µm, 2 µm, and 77 µm in a particle size distribution as illustrated in Figure 9a, and a particle diameter for which a cumulative volume calculated from a small diameter side was 10% was 0.6 µm, a particle diameter for which a cumulative volume was 50% was 2.6 µm, and a particle diameter for which a cumulative volume was 90% was 38.9 µm, as illustrated in Table 5. As a shell substance, hydrophilic fumed alumina particles (article number "AEROXIDE (Japanese registered trademark) Alu C") which were the same as in Example 1 were prepared. Then, 30 vol% of the core substance (ZnO powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 13 µm and a particle diameter of 45 µm, as illustrated in Figure 9a. As illustrated in Table 5, in the particle diameter distribution of the composite filler, a particle diameter for which a cumulative volume calculated from a small diameter side was 10% was 1.7 µm, a particle diameter for which a cumulative volume was 50% was 14.5 µm, and a particle diameter for which a cumulative volume was 90% was 63.3 µm. Since particle diameters in the particle size distribution of the ZnO powder covered a wide range from 0.06 µm to 300 µm, a thickness of a shell substance layer was difficult to calculate. Figure 9b illustrates a scanning electron microscope (SEM) photograph of the ZnO powder, and Figure 9c illustrates a scanning electron microscope (SEM) photograph of the composite filler.

**[Table 5]**

| | ZnO | Alu C+ZnO |
|---|---|---|
| 10% diameter on volumetric basis | 0.6 µm | 1.7 µm |
| 50% diameter on volumetric basis | 2.6 µm | 14.5 µm |
| 90% diameter on volumetric basis | 38.9 µm | 63.3 µm |

### <Example 6>

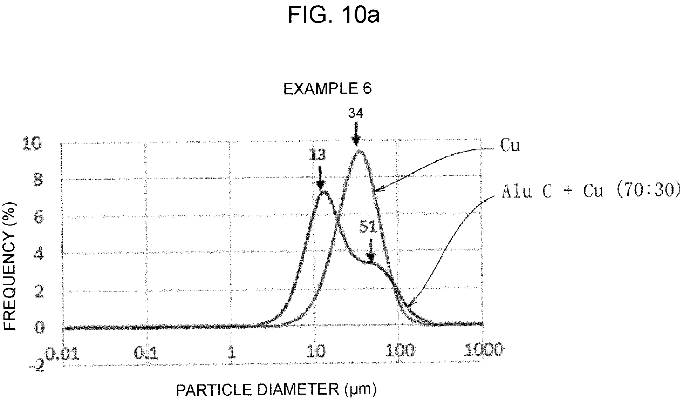

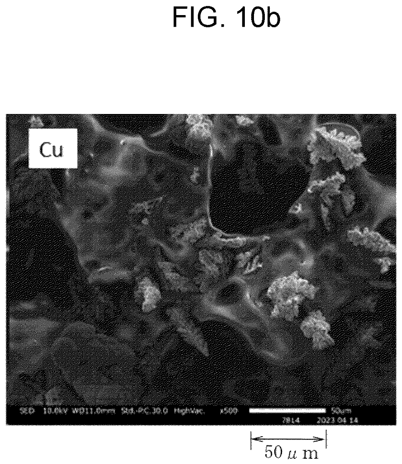

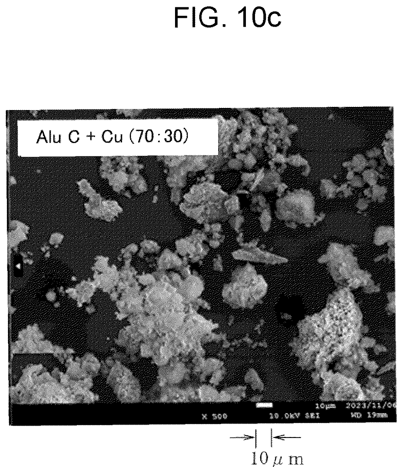

As a core substance, Cu (copper) powder was prepared. The Cu powder had one peak particle diameter of 34 µm in a particle size distribution as illustrated in Figure 10a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 6. As a shell substance, hydrophilic fumed alumina particles (article number "AEROXIDE (Japanese registered trademark) Alu C") which were the same as in Example 1 were prepared. Then, 30 vol% of the core substance (Cu powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 13 µm and a particle diameter of 51 µm, as illustrated in Figure 10a. As illustrated in Table 6, in the particle diameter distribution of the composite filler, a particle diameter for which a cumulative volume calculated from a small diameter side was 10% was 6.8 µm, a particle diameter for which a cumulative volume was 50% was 16.4 µm, and a particle diameter for which a cumulative volume was 90% was 66.3 µm. Since particle diameters in the particle size distribution of the Cu powder covered a wide range from 5 µm to 175 µm, a thickness of a shell substance layer was difficult to calculate. The thickness of the shell substance layer was conveniently estimated to be 51 µm-34 µm = 17 µm. Figure 10b illustrates a scanning electron microscope (SEM) photograph of the Cu powder, and Figure 10c illustrates a scanning electron microscope (SEM) photograph of the composite filler.

**[Table 6]**

| | Cu | Alu C+Cu |
|---|---|---|
| 10% diameter on volumetric basis | 13.5 µm | 6.8 µm |
| 50% diameter on volumetric basis | 30.6 µm | 16.4 µm |
| 90% diameter on volumetric basis | 62.0 µm | 66.3 µm |

### <Example 7>

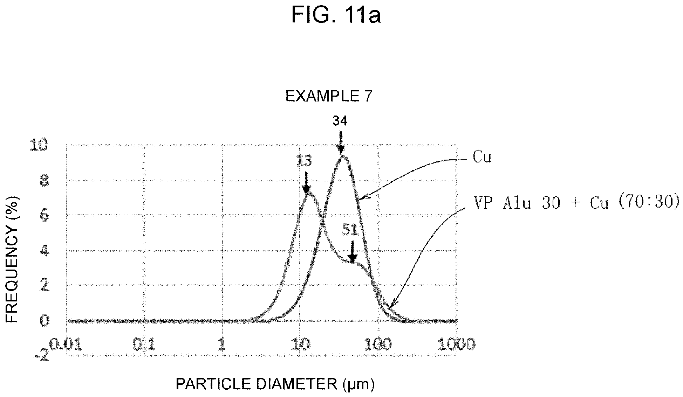

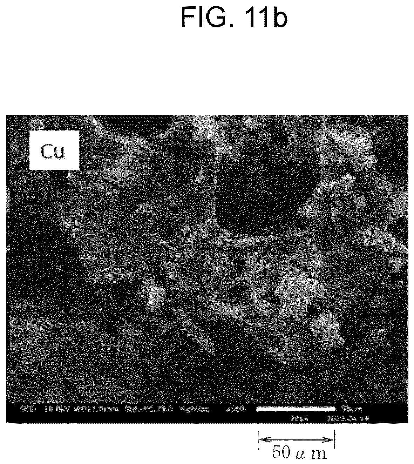

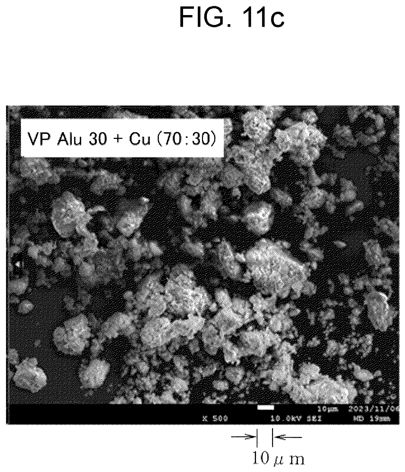

As a core substance, Cu (copper) powder that was the same as in Example 6 was prepared. The Cu powder had one peak particle diameter of 34 µm in a particle size distribution as illustrated in Figure 11a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 7. As a shell substance, hydrophilic fumed alumina particles (article number "VP Alu 30") were prepared. Then, 30 vol% of the core substance (Cu powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 13 µm and a particle diameter of 51 µm, as illustrated in Figure 11a. As illustrated in Table 7, in the particle diameter distribution of the composite filler, a particle diameter for which a cumulative volume calculated from a small diameter side was 10% was 6.8 µm, a particle diameter for which a cumulative volume was 50% was 16.4 µm, and a particle diameter for which a cumulative volume was 90% was 66.3 µm, which was no different from Example 6. Since particle diameters in the particle size distribution of the Cu powder covered a wide range from 5 µm to 175 µm, a thickness of a shell substance layer was difficult to calculate. The thickness of the shell substance layer was conveniently estimated to be 51 µm-34 µm = 17 µm. Figure 11b illustrates a scanning electron microscope (SEM) photograph of the Cu powder, and Figure 11c illustrates a scanning electron microscope (SEM) photograph of the composite filler.

**[Table 7]**

| | Cu | VP Alu 30+Cu |
|---|---|---|
| 10% diameter on volumetric basis | 13.5 µm | 6.8 µm |
| 50% diameter on volumetric basis | 30.6 µm | 16.4 µm |
| 90% diameter on volumetric basis | 62.0 µm | 66.3 µm |

### <Example 8>

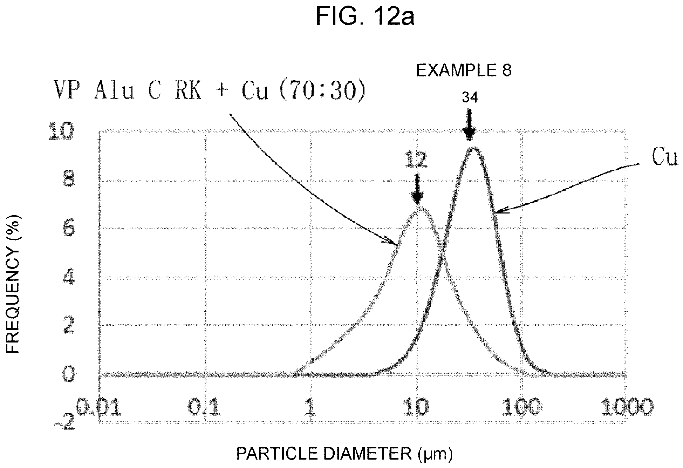

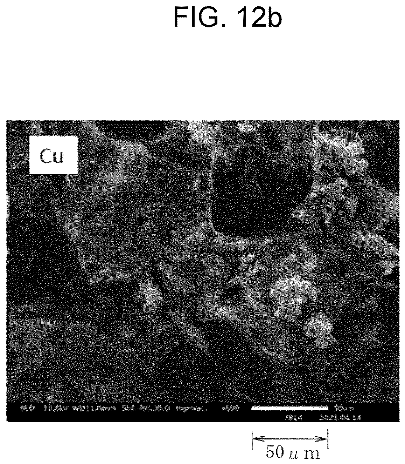

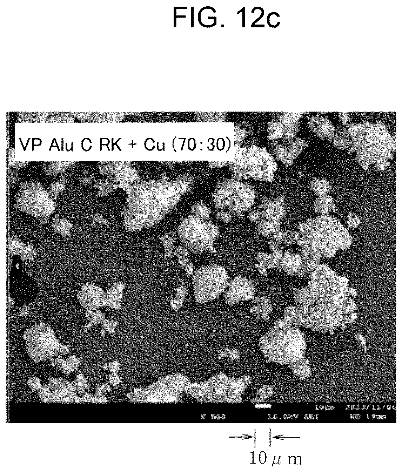

As a core substance, Cu (copper) powder that was the same as in Example 6 was prepared. The Cu powder had one peak particle diameter of 34 µm in a particle size distribution as illustrated in Figure 12a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 8. As a shell substance, hydrophobic fumed alumina particles (article number "VP Alu C RK") were prepared. Then, 30 vol% of the core substance (Cu powder) and 70 vol% of the shell substance (fumed alumina particles) were dryly mixed using the same dry ball mill as Example 1 by the same method as Example 1 to obtain a composite filler. A particle diameter distribution of the composite filler had one peak at a particle diameter of 12 µm, as illustrated in Figure 12a. As illustrated in Table 8, in the particle diameter distribution of the composite filler, a particle diameter for which a cumulative volume calculated from a small diameter side was 10% was 2.6 µm, a particle diameter for which a cumulative volume was 50% was 9.2 µm, and a particle diameter for which a cumulative volume was 90% was 26.5 µm. Since particle diameters in the particle size distribution of the Cu powder covered a wide range from 5 µm to 175 µm, a thickness of a shell substance layer was difficult to calculate. Figure 12b illustrates a scanning electron microscope (SEM) photograph of the Cu powder, and Figure 12c illustrates a scanning electron microscope (SEM) photograph of the composite filler.

**[Table 8]**

| | Cu | VP Alu C RK+Cu |
|---|---|---|
| 10% diameter on volumetric basis | 13.5 µm | 2.6 µm |
| 50% diameter on volumetric basis | 30.6 µm | 9.2 µm |
| 90% diameter on volumetric basis | 62.0 µm | 26.5 µm |

### <Example 9>

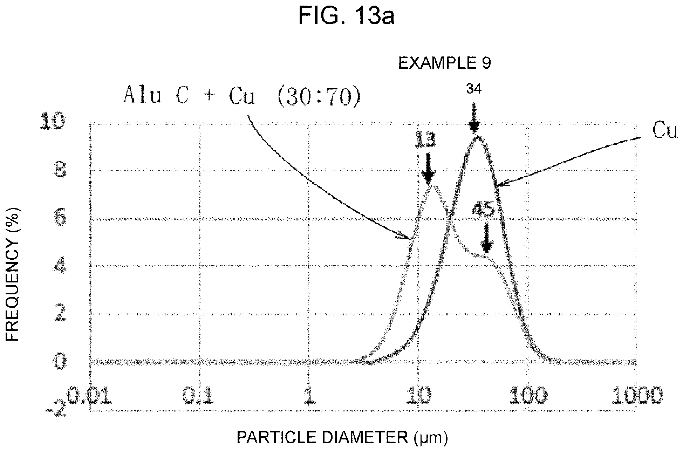

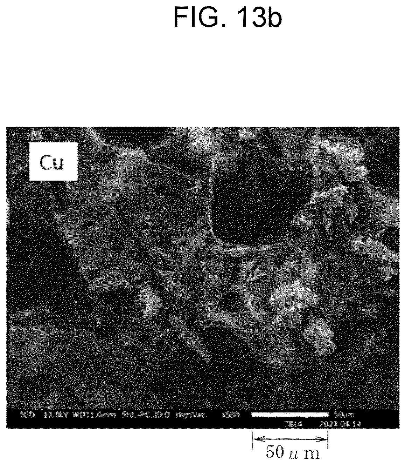

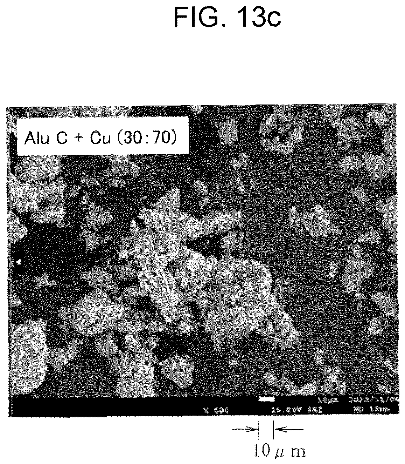

As a core substance, Cu (copper) powder that was the same as in Example 6 was prepared. The Cu powder had one peak particle diameter of 34 µm in a particle size distribution as illustrated in Figure 13a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 9. As a shell substance, hydrophilic fumed alumina particles (article number "AEROXIDE (Japanese registered trademark) Alu C") were prepared. Then, 70 vol% of the core substance (Cu powder) and 30 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 13 µm and a particle diameter of 45 µm, as illustrated in Figure 13a. As illustrated in Table 9, in the particle diameter distribution of the composite filler, a particle diameter for which a cumulative volume calculated from a small diameter side was 10% was 7.3 µm, a particle diameter for which a cumulative volume was 50% was 17.2 µm, and a particle diameter for which a cumulative volume was 90% was 55.7 µm. Since particle diameters in the particle size distribution of the Cu powder covered a wide range from 5 µm to 175 µm, a thickness of a shell substance layer was difficult to calculate. The thickness of the shell substance layer was conveniently estimated to be 45 µm-34 µm = 11 µm. Figure 13b illustrates a scanning electron microscope (SEM) photograph of the Cu powder, and Figure 13c illustrates a scanning electron microscope (SEM) photograph of the composite filler.

**[Table 9]**

| | Cu | Alu C+Cu |
|---|---|---|
| 10% diameter on volumetric basis | 13.5 µm | 7.3 µm |
| 50% diameter on volumetric basis | 30.6 µm | 17.2 µm |
| 90% diameter on volumetric basis | 62.0 µm | 55.7 µm |

### <Example 10>

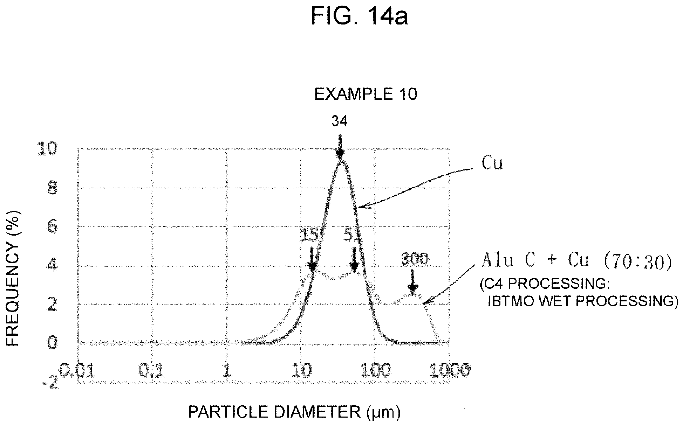

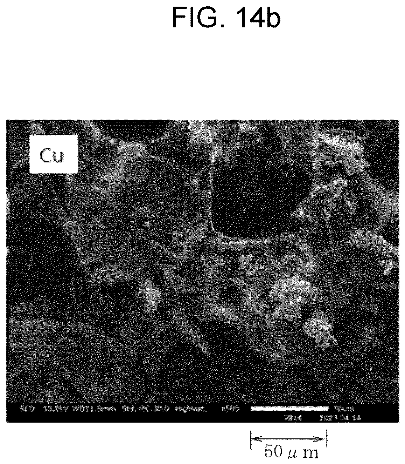

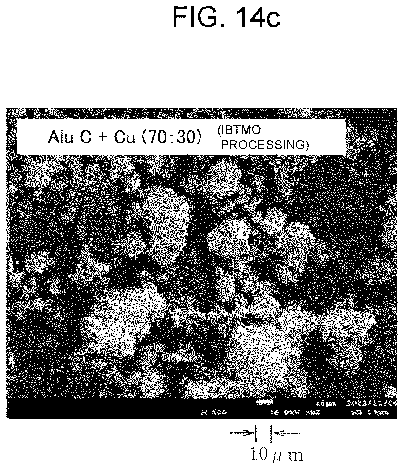

As a core substance, Cu (copper) powder that was the same as in Example 6 was prepared. The Cu powder had one peak particle diameter of 34 µm in a particle size distribution as illustrated in Figure 14a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 10. As a shell substance, hydrophilic fumed alumina particles (article number "AEROXIDE (Japanese registered trademark) Alu C") which were the same as in Example 1 were prepared. Then, after 30 vol% of the core substance (Cu powder) and 70 vol% of the shell substance (fumed alumina particles) were dryly mixed using the same dry ball mill as Example 1 by the same method as Example 1, a surface of the mixed powder was hydrophobized by wet processing (hereinafter referred to as C4 processing) using isobutyl(trimethoxy)silane that is a silane coupling agent to obtain a composite filler. The C4 processing was a process of charging the mixed powder into a beaker containing IBTMO, heat-treating a mixture at a temperature of 120°C in the atmosphere using a magnetic stirrer with a hot plate (manufactured by TOKYO RIKAKIKAI CO., LTD.: model number "RH-1000"), and then drying the mixture at 150°C in the atmosphere for 1 hour. The dried mixture was used as the composite filler without any further treatment. A particle diameter distribution of the composite filler had three peaks at a particle diameter of 15 µm, a particle diameter of 51 µm, and a particle diameter of 300 µm, as illustrated in Figure 14a. As illustrated in Table 10, in the particle diameter distribution of the composite filler, a particle diameter for which a cumulative volume calculated from a small diameter side was 10% was 8.2 µm, a particle diameter for which a cumulative volume was 50% was 40.3 µm, and a particle diameter for which a cumulative volume was 90% was 298.9 µm. Since particle diameters in the particle size distribution of the Cu powder covered a wide range from 5 µm to 175 µm, a thickness of a shell substance layer was difficult to calculate. The thickness of the shell substance layer was conveniently estimated to be 51 µm-34 µm = 17 µm. Figure 14b illustrates a scanning electron microscope (SEM) photograph of the Cu powder, and Figure 14c illustrates a scanning electron microscope (SEM) photograph of the composite filler.

**[Table 10]**

| | Cu | Alu C+Cu (C4 processing) |
|---|---|---|
| 10% diameter on volumetric basis | 13.5 µm | 8.2 µm |
| 50% diameter on volumetric basis | 30.6 µm | 40.3 µm |
| 90% diameter on volumetric basis | 62.0 µm | 298.9 µm |

### <Example 11>

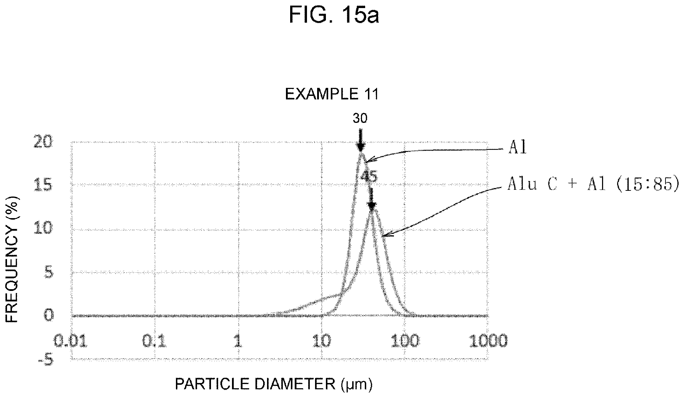

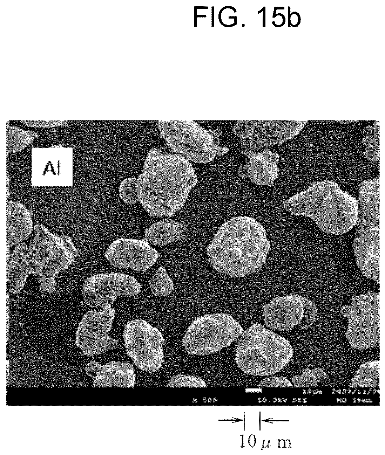

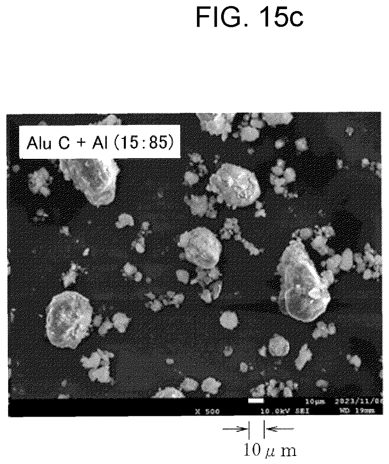

As a core substance, Al (aluminum) powder was prepared. The Al powder had one peak particle diameter of 30 µm in a particle size distribution as illustrated in Figure 15a, and a particle diameter for which a cumulative volume calculated from a small diameter side was 10% was 20.3 µm, a particle diameter for which a cumulative volume was 50% was 30.2 µm, and a particle diameter for which a cumulative volume was 90% was 47.9 µm, as illustrated in Table 11. As a shell substance, hydrophilic fumed alumina particles (article number "AEROXIDE (Japanese registered trademark) Alu C") which were the same as in Example 1 were prepared. Then, 85 vol% of the core substance (Al powder) and 15 vol% of the shell substance (fumed alumina particles) were dryly mixed using the same dry ball mill as Example 1 by the same method as Example 1 to obtain a composite filler. A particle diameter distribution of the composite filler had one peak at a particle diameter of 45 µm, as illustrated in Figure 15a. As illustrated in Table 11, in the particle diameter distribution of the composite filler, a particle diameter for which a cumulative volume calculated from a small diameter side was 10% was 10.2 µm, a particle diameter for which a cumulative volume was 50% was 35.3 µm, and a particle diameter for which a cumulative volume was 90% was 60.1 µm. Since particle diameters in the particle size distribution of the Al powder covered a relatively narrow range from 12 µm to 77 µm, a thickness of a shell substance layer was estimated to be 45 µm-30 µm = 15 µm. Figure 15b illustrates a scanning electron microscope (SEM) photograph of the Al powder, and Figure 15c illustrates a scanning electron microscope (SEM) photograph of the composite filler.

**[Table 11]**

| | Al | Alu C+Al |
|---|---|---|
| 10% diameter on volumetric basis | 20.3 µm | 10.2 µm |
| 50% diameter on volumetric basis | 30.2 µm | 35.3 µm |
| 90% diameter on volumetric basis | 47.9 µm | 60.1 µm |

### <Example 12>

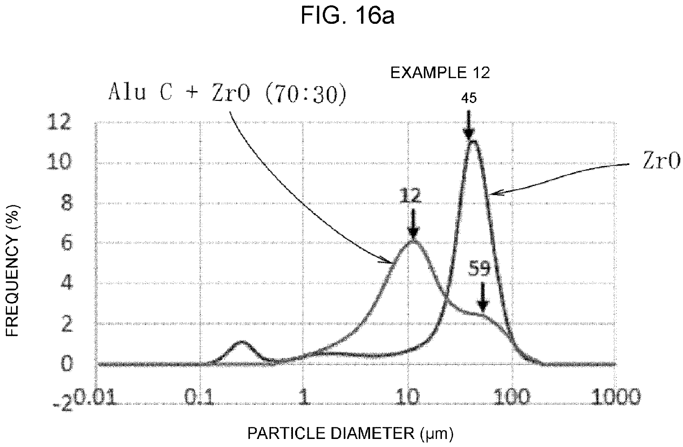

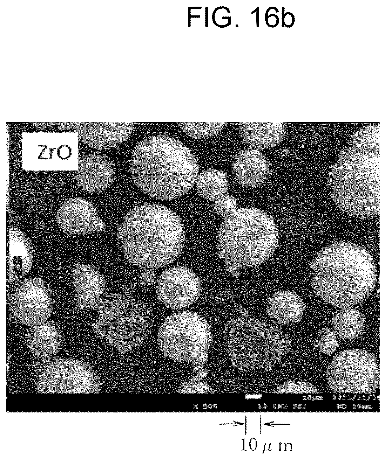

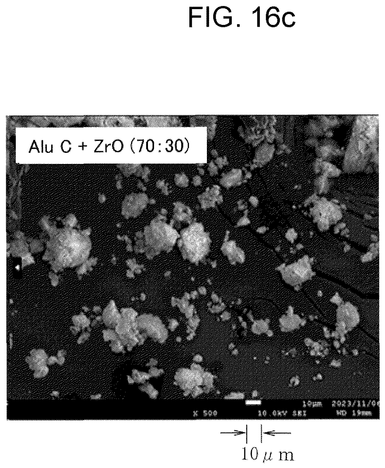

As a core substance, ZrO (zirconium oxide) powder was prepared. The ZrO powder had one peak particle diameter of 45 µm in a particle size distribution as illustrated in Figure 16a, and a particle diameter for which a cumulative volume calculated from a small diameter side was 10% was 2.0 µm, a particle diameter for which a cumulative volume was 50% was 35.9 µm, and a particle diameter for which a cumulative volume was 90% was 65.1 µm, as illustrated in Table 12. As a shell substance, hydrophilic fumed alumina particles (article number "AEROXIDE (Japanese registered trademark) Alu C") which were the same as in Example 1 were prepared. Then, 30 vol% of the core substance (ZrO powder) and 70 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 12 µm and a particle diameter of 59 µm, as illustrated in Figure 16a. As illustrated in Table 12, in the particle diameter distribution of the composite filler, a particle diameter for which a cumulative volume calculated from a small diameter side was 10% was 3.2 µm, a particle diameter for which a cumulative volume was 50% was 11.4 µm, and a particle diameter for which a cumulative volume was 90% was 52.7 µm. Since particle diameters in the particle size distribution of the ZrO powder covered a relatively wide range from 0.2 µm to 150 µm, a thickness of a shell substance layer was difficult to calculate. The thickness of the shell substance layer was conveniently estimated to be 59 µm-45 µm = 14 µm. Figure 16b illustrates a scanning electron microscope (SEM) photograph of the ZrO powder, and Figure 16c illustrates a scanning electron microscope (SEM) photograph of the composite filler.

**[Table 12]**

| | ZrO | Alu C+ZrO |
|---|---|---|
| 10% diameter on volumetric basis | 2.0 µm | 3.2 µm |
| 50% diameter on volumetric basis | 35.9 µm | 11.4 µm |
| 90% diameter on volumetric basis | 65.1 µm | 52.7 µm |

### <Example 13>

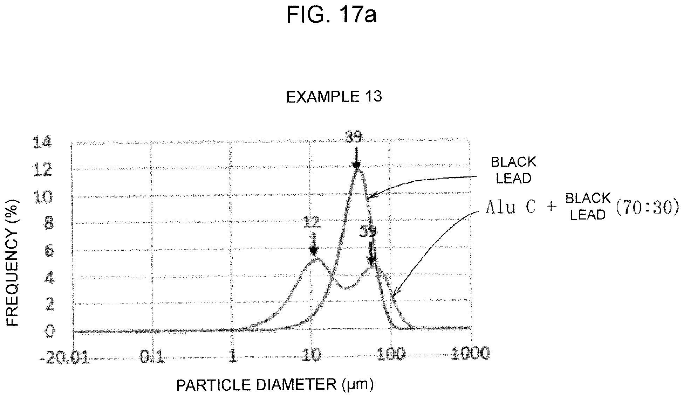

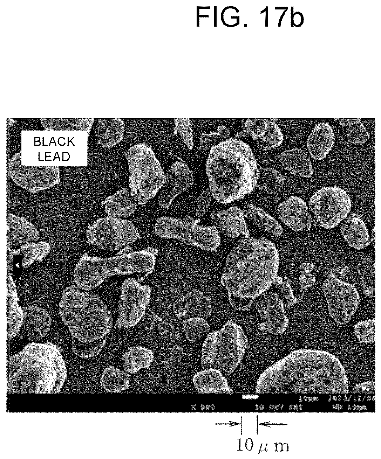

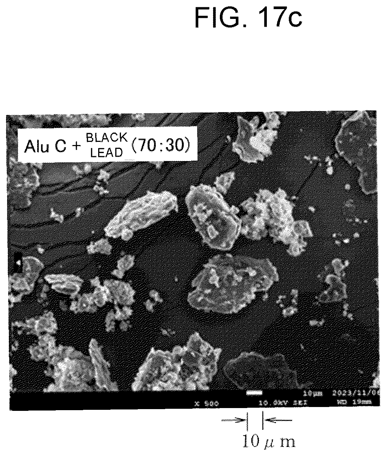

As a core substance, black lead powder was prepared. The black lead powder had one peak particle diameter of 39 µm in a particle size distribution as illustrated in Figure 17a, and a particle diameter for which a cumulative volume calculated from a small diameter side was 10% was 15.8 µm, a particle diameter for which a cumulative volume was 50% was 34.2 µm, and a particle diameter for which a cumulative volume was 90% was 57.9 µm, as illustrated in Table 13. As a shell substance, hydrophilic fumed silica particles (article number "AEROSIL (Japanese registered trademark) 380S") were prepared. Then, 30 vol% of the core substance (black lead powder) and 70 vol% of the shell substance (fumed silica particles) were dryly mixed using the same dry ball mill as Example 1 by the same method as Example 1 to obtain a composite filler. A particle diameter distribution of the composite filler had two peaks at a particle diameter of 12 µm and a particle diameter of 59 µm, as illustrated in Figure 17a. As illustrated in Table 13, in the particle diameter distribution of the composite filler, a particle diameter for which a cumulative volume calculated from a small diameter side was 10% was 5.3 µm, a particle diameter for which a cumulative volume was 50% was 18.3 µm, and a particle diameter for which a cumulative volume was 90% was 76.7 µm. Since particle diameters in the particle size distribution of the black lead powder covered a relatively wide range from 4 µm to 101 µm, a thickness of a shell substance layer was difficult to calculate. The thickness of the shell substance layer was conveniently estimated to be 59 µm-39 µm = 20 µm. Figure 17b illustrates a scanning electron microscope (SEM) photograph of the black lead powder, and Figure 17c illustrates a scanning electron microscope (SEM) photograph of the composite filler.

**[Table 13]**

| | Black lead | 380S+black lead |
|---|---|---|
| 10% diameter on volumetric basis | 15.8 µm | 5.3 µm |
| 50% diameter on volumetric basis | 34.2 µm | 18.3 µm |
| 90% diameter on volumetric basis | 57.9 µm | 76.7 µm |

### <Comparative Example 1>

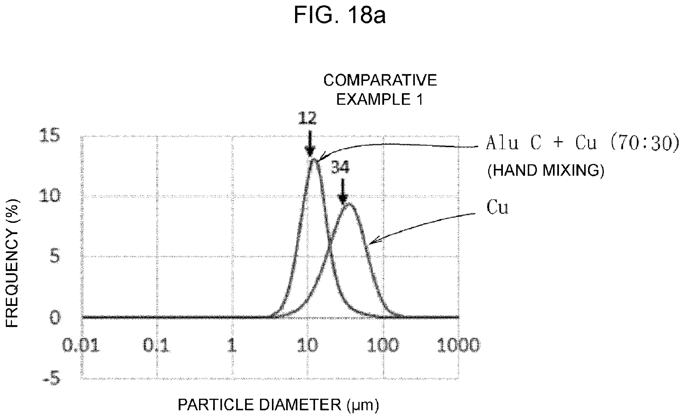

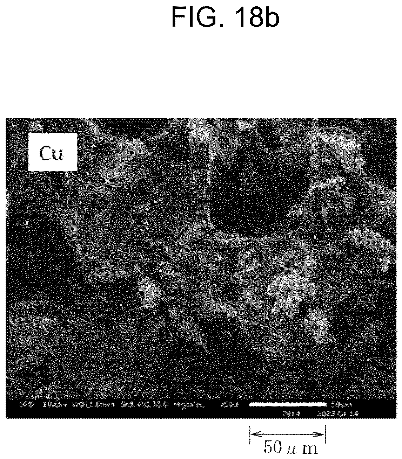

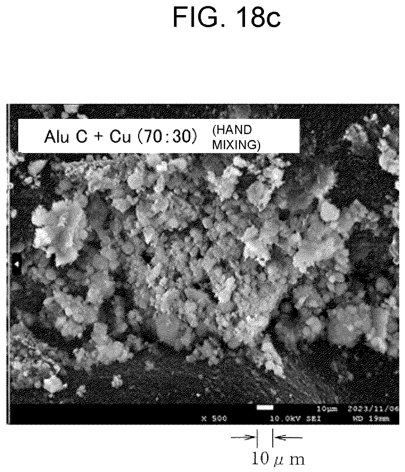

As a core substance, Cu (copper) powder that was the same as in Example 6 was prepared. The Cu powder had one peak particle diameter of 34 µm in a particle size distribution as illustrated in Figure 18a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 14. As a shell substance, hydrophilic fumed alumina particles (article number "AEROXIDE (Japanese registered trademark) Alu C") which were the same as in Example 1 were prepared. Then, 30 vol% of the core substance (Cu powder) and 70 vol% of the shell substance (fumed alumina particles) were put in a polyethylene bag in the atmosphere and were mixed by a hand mixing method that mixes the contents of the polyethylene bag with a gloved hand for 1 minute to obtain a composite filler. A particle diameter distribution of the composite filler had one peak at a particle diameter of 12 µm, as illustrated in Figure 18a. As illustrated in Table 14, in the particle diameter distribution of the composite filler, a particle diameter for which a cumulative volume calculated from a small diameter side was 10% was 6.7 µm, a particle diameter for which a cumulative volume was 50% was 11.4 µm, and a particle diameter for which a cumulative volume was 90% was 20.4 µm. Since a particle size distribution of the composite filler after hand mixing had one sharp peak, and the Cu powder as the core substance was supposedly a substance so weakly aggregated that the substance was loosened by hand mixing, a thickness of a shell substance layer was difficult to calculate. Figure 18b illustrates a scanning electron microscope (SEM) photograph of the Cu powder, and Figure 18c illustrates a scanning electron microscope (SEM) photograph of the composite filler.

**[Table 14]**

| | Cu | Alu C+Cu (hand mixing) |
|---|---|---|
| 10% diameter on volumetric basis | 13.5 µm | 6.7 µm |
| 50% diameter on volumetric basis | 30.6 µm | 11.4 µm |
| 90% diameter on volumetric basis | 62.0 µm | 20.4 µm |

### <Comparative Example 2>

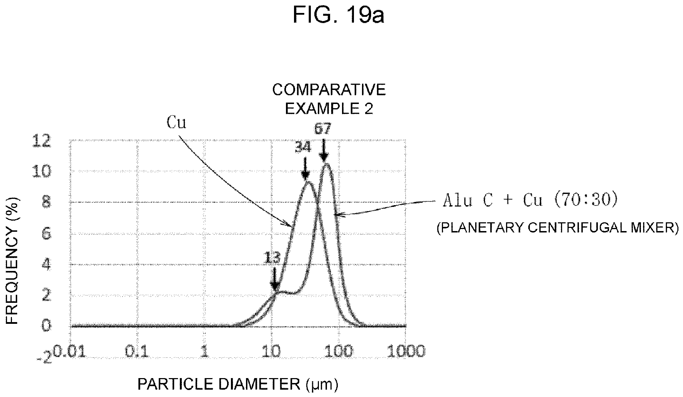

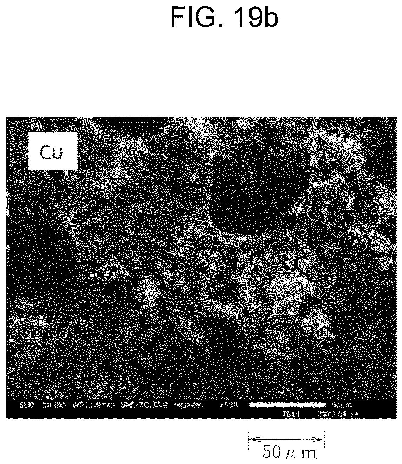

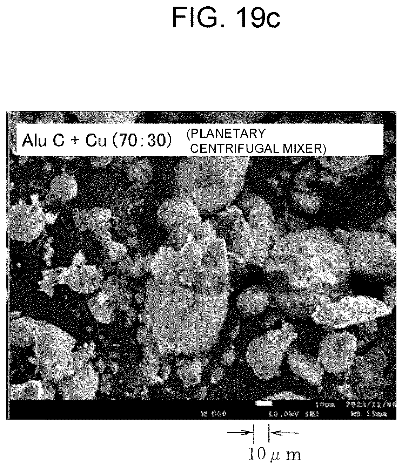

As a core substance, Cu (copper) powder that was the same as in Example 6 was prepared. The Cu powder had one peak particle diameter of 34 µm in a particle size distribution as illustrated in Figure 19a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 15. As a shell substance, hydrophilic fumed alumina particles (article number "AEROXIDE (Japanese registered trademark) Alu C") which were the same as in Example 1 were prepared. Then, 30 vol% of the core substance (Cu powder) and 70 vol% of the shell substance (fumed alumina particles) were mixed in the atmosphere at 2,000 rpm for 3 minutes using a planetary centrifugal mixer (manufactured by THINKY CORPORATION: Awatori Rentarou, model number "ARE-310") to obtain a composite filler. A particle diameter distribution of the composite filler had two peaks at a particle diameter of 13 µm and a particle diameter of 67 µm, as illustrated in Figure 19a. As illustrated in Table 15, in the particle diameter distribution of the composite filler, a particle diameter for which a cumulative volume calculated from a small diameter side was 10% was 11.2 µm, a particle diameter for which a cumulative volume was 50% was 51.2 µm, and a particle diameter for which a cumulative volume was 90% was 91.9 µm. Since a particle size distribution of the composite filler had a main peak diameter of 67 µm, which was significantly different from Example 6 with composition by a dry ball mill, a thickness of a shell substance layer was estimated to be 67 µm-34 µm = 33 µm. Figure 19b illustrates a scanning electron microscope (SEM) photograph of the Cu powder, and Figure 19c illustrates a scanning electron microscope (SEM) photograph of the composite filler.

**[Table 15]**

| | Cu | Alu C+Cu (planetary centrifugal mixer) |
|---|---|---|
| 10% diameter on volumetric basis | 13.5 µm | 11.2 µm |
| 50% diameter on volumetric basis | 30.6 µm | 51.2 µm |
| 90% diameter on volumetric basis | 62.0 µm | 91.9 µm |

### <Comparative Example 3>

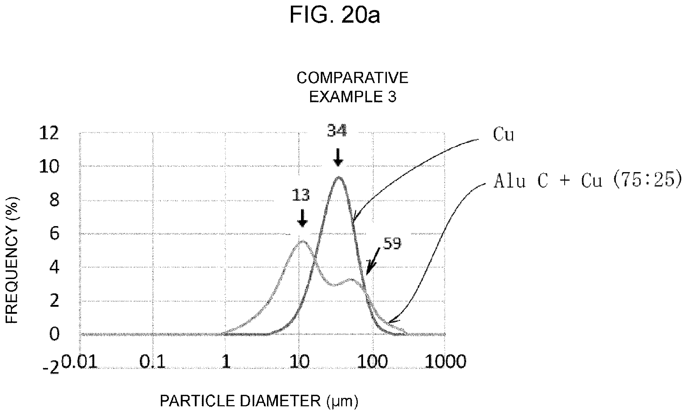

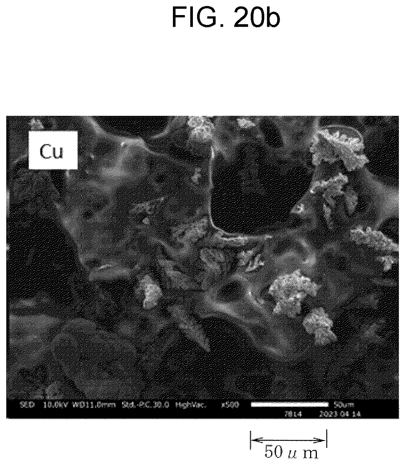

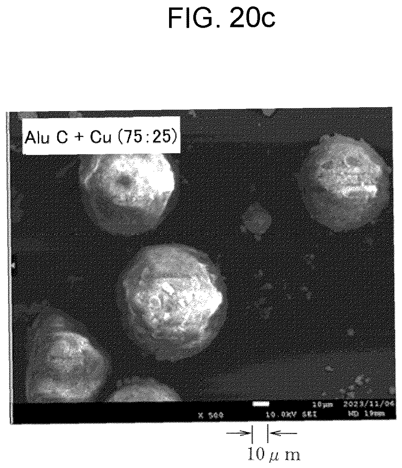

As a core substance, Cu (copper) powder that was the same as in Example 6 was prepared. The Cu powder had one peak particle diameter of 34 µm in a particle size distribution as illustrated in Figure 20a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 16. As a shell substance, hydrophilic fumed alumina particles (article number "AEROXIDE (Japanese registered trademark) Alu C") which were the same as in Example 1 were prepared. Then, 25 vol% of the core substance (Cu powder) and 75 vol% of the shell substance (fumed alumina particles) were dryly mixed using the same dry ball mill as Example 1 by the same method as Example 1 to obtain a composite filler. A particle diameter distribution of the composite filler had two peaks at a particle diameter of 13 µm and a particle diameter of 59 µm, as illustrated in Figure 20a. As illustrated in Table 16, in the particle diameter distribution of the composite filler, a particle diameter for which a cumulative volume calculated from a small diameter side was 10% was 4.1 µm, a particle diameter for which a cumulative volume was 50% was 13.8 µm, and a particle diameter for which a cumulative volume was 90% was 71.0 µm. Since particle diameters in the particle size distribution of the Cu powder covered a wide range from 5 µm to 175 µm, a thickness of a shell substance layer was difficult to calculate. The thickness of the shell substance layer was conveniently estimated to be 59 µm-34 µm = 25 µm. Figure 20b illustrates a scanning electron microscope (SEM) photograph of the Cu powder, and Figure 20c illustrates a scanning electron microscope (SEM) photograph of the composite filler.

**[Table 16]**

| | Cu | Alu C+Cu |
|---|---|---|
| 10% diameter on volumetric basis | 13.5 µm | 4.1 µm |
| 50% diameter on volumetric basis | 30.6 µm | 13.8 µm |
| 90% diameter on volumetric basis | 62.0 µm | 71.0 µm |

### <Comparative Example 4>

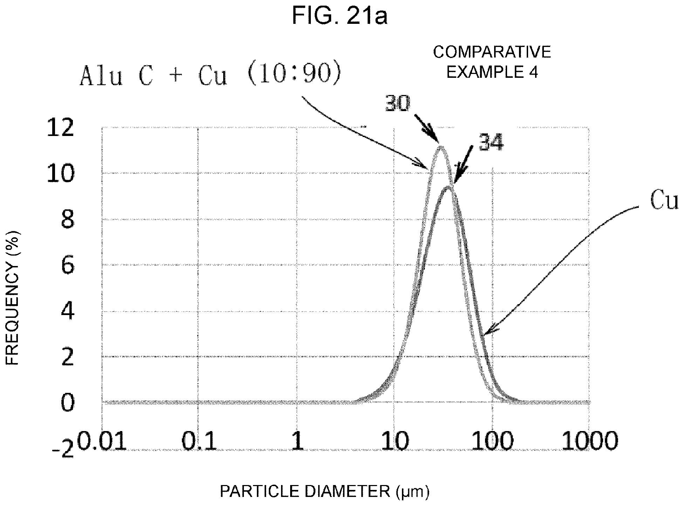

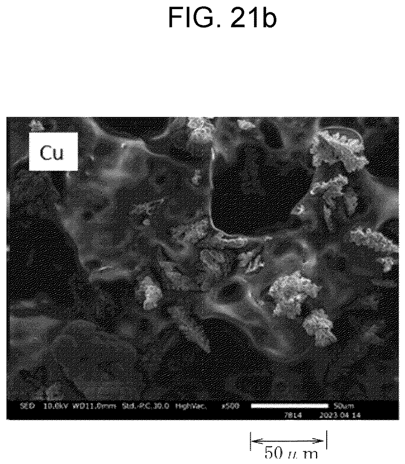

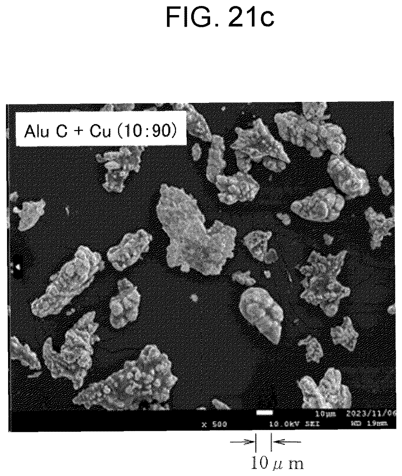

As a core substance, Cu (copper) powder that was the same as in Example 6 was prepared. The Cu powder had one peak particle diameter of 34 µm in a particle size distribution as illustrated in Figure 21a, and a particle diameter for which a cumulative volume calculated from a small diameter side was 10% was 13.5 µm, a particle diameter for which a cumulative volume was 50% was 30.6 µm, and a particle diameter for which a cumulative volume was 90% was 62.0 µm, as illustrated in Table 17. As a shell substance, hydrophilic fumed alumina particles (article number "AEROXIDE (Japanese registered trademark) Alu C") which were the same as in Example 1 were prepared. Then, 90 vol% of the core substance (Cu powder) and 10 vol% of the shell substance (fumed alumina particles) were dryly mixed using the same dry ball mill as Example 1 by the same method as Example 1 to obtain a composite filler. A particle diameter distribution of the composite filler had one peak at a particle diameter of 30 µm, as illustrated in Figure 21a. As illustrated in Table 17, in the particle diameter distribution of the composite filler, a particle diameter for which a cumulative volume calculated from a small diameter side was 10% was 14.0 µm, a particle diameter for which a cumulative volume was 50% was 27.1 µm, and a particle diameter for which a cumulative volume was 90% was 50.2 µm. Since a particle size distribution of the composite filler after the mixing had one sharp peak slightly shifted to a small diameter side, a thickness of a shell substance layer was difficult to calculate. Figure 21b illustrates a scanning electron microscope (SEM) photograph of the Cu powder, and Figure 21c illustrates a scanning electron microscope (SEM) photograph of the composite filler.

**[Table 17]**

| | Cu | Alu C+Cu |
|---|---|---|
| 10% diameter on volumetric basis | 13.5 µm | 14.0 µm |
| 50% diameter on volumetric basis | 30.6 µm | 27.1 µm |
| 90% diameter on volumetric basis | 62.0 µm | 50.2 µm |

### <Comparative Example 5>

A filler consisting of Cu (copper) powder that was the same as in Example 6 was made.

### <Comparative Example 6>

A filler consisting of Al (aluminum) powder that was the same as in Example 11 was made.

### <Comparative Example 7>

A filler consisting of Sn (tin) powder that was the same as in Example 1 was made.

Details of the core substances and shell substances according to Examples 1 to 13 and Comparative Examples 1 to 4 described above and mixing methods therefor are illustrated in Table 18. Compositions of the composite fillers and physical properties of the composite fillers are illustrated in Table 19. Note that although the fillers according to Comparative Examples 5 to 7 consist only of core substances that are not composite, the fillers are brought under column headings with the wording "composite filler".

**[Table 18]**

| | Core substance | | | | | Shell substance | | | | Mixing method |
|---|---|---|---|---|---|---|---|---|---|---|
| | Material | Particle diameter (µm) | | | Mixing ratio (vol%) | Article number | Material | Average particle diameter (nm) | Mixing ratio (vol%) | |
| Ex. 1 | Sn | 17 | | | 30 | Alu C | Al₂O₃ | 13 | 70 | dry ball mill |
| Ex. 2 | Zn | 9 | | | 30 | Alu C | Al₂O₃ | 13 | 70 | dry ball mill |
| Ex. 3 | Ni | 10 | | | 30 | Alu C | Al₂O₃ | 13 | 70 | dry ball mill |
| Ex. 4 | SUS | 89 | | | 30 | Alu C | Al₂O₃ | 13 | 70 | dry ball mill |
| Ex. 5 | ZnO | 0.09 | 2 | 77 | 30 | Alu C | Al₂O₃ | 13 | 70 | dry ball mill |
| Ex. 6 | Cu | 34 | | | 30 | Alu C | Al₂O₃ | 13 | 70 | dry ball mill |
| Ex. 7 | Cu | 34 | | | 30 | VP Alu 30 | Al₂O₃ | 90 | 70 | dry ball mill |
| Ex. 8 | Cu | 34 | | | 30 | VP Alu C RK | Al₂O₃ | 13 | 70 | dry ball mill |
| Ex. 9 | Cu | 34 | | | 70 | Alu C | Al₂O₃ | 13 | 30 | dry ball mill |
| Ex. 10 | Cu | 34 | | | 30 | Alu C | Al₂O₃ | 13 | 70 | dry ball mill+C4 processing |
| Ex. 11 | Al | 30 | | | 85 | Alu C | Al₂O₃ | 13 | 15 | dry ball mill |
| Ex. 12 | ZrO | 45 | | | 30 | Alu C | Al₂O₃ | 13 | 70 | dry ball mill |
| Ex. 13 | black lead | 39 | | | 30 | 380S | SiO₂ | 7 | 70 | dry ball mill |
| Comp. Ex. 1 | Cu | 34 | | | 30 | Alu C | Al₂O₃ | 13 | 70 | dry hand mixing |
| Comp. Ex. 2 | Cu | 34 | | | 30 | Alu C | Al₂O₃ | 13 | 70 | dry planetary centrifugal mixer |
| | Cu | 34 | | | 25 | Alu C | Al₂O₃ | 13 | 75 | dry ball mill |
| Comp. Ex. 3 | | | | | | | | | | |
| Comp. Ex. 4 | Cu | 34 | 90 | Alu C | Al₂O₃ | 13 | 10 | dry ball mill | | |
| Comp. Ex. 5 | Cu | 34 | 100 | - | - | - | - | - | | |
| Comp. Ex. 6 | Al | 30 | 100 | - | - | - | - | - | | |
| Comp. Ex. 7 | Sn | 17 | 100 | - | - | - | - | - | | |

**[Table 19]**

| | Composition of composite filler | | | | Physical property of composite filler | | | | | | | |
|---|---|---|---|---|---|---|---|---|---|---|---|---|
| | Core substance | | Shell substance | | Peak particle diameter (µm) | | | | Thermal conductivity (W/m·K) | Thermal conduction ratio normalized based on copper powder (%) | Volume resistivity (Ω·cm) | Dielectric breakdown voltage (kV/mm) |
| | Material | Volume % | Material | Volume % | | | | | | | | |
| Ex. 1 | Sn | 30 | Al₂O₃ | 70 | 12 | | 67 | | 0.086 | 68 | 4.2×10⁶ | 7.8 |
| Ex. 2 | Zn | 30 | Al₂O₃ | 70 | 12 | | 67 | | 0.075 | 60 | 2.0×10⁶ | 9.0 |
| Ex. 3 | Ni | 30 | Al₂O₃ | 70 | 12 | | | | 0.100 | 79 | 7.4×10⁵ | 9.4 |
| Ex. 4 | SUS | 30 | Al₂O₃ | 70 | 12 | | 67 | | 0.085 | 68 | 2.0×10⁵ | 6.5 |
| Ex. 5 | ZnO | 30 | Al₂O₃ | 70 | 13 | | 45 | | 0.093 | 74 | 3.4×10⁵ | 3.2 |
| Ex. 6 | Cu | 30 | Al₂O₃ | 70 | 13 | | 51 | | 0.086 | 69 | 5.7×10⁵ | 4.6 |
| Ex. 7 | Cu | 30 | Al₂O₃ | 70 | 13 | | 51 | | 0.077 | 61 | 6.7×10⁵ | 1.3 |
| Ex. 8 | Cu | 30 | Al₂O₃ | 70 | 12 | | | | 0.080 | 64 | 3.6×10¹⁰ | 5.0 |
| Ex. 9 | Cu | 70 | Al₂O₃ | 30 | 13 | | 45 | | 0.128 | 102 | 7.6×10⁶ | 1.2 |
| Ex. 10 | Cu | 30 | Al₂O₃ | 70 | 15 | 51 | | 300 | 0.105 | 84 | 1.9×10⁷ | 1.3 |
| Ex. 11 | Al | 85 | Al₂O₃ | 15 | 45 | | | | 0.100 | 80 | 4.0×10⁵ | 2.3 |
| Ex. 12 | ZrO | 30 | Al₂O₃ | 70 | 12 | | 59 | | 0.079 | 63 | 1.2×10⁵ | 5.0 |
| Ex. 13 | black lead | 30 | SiO₂ | 70 | 12 | | 59 | | 0.610 | 484 | 4.2×10⁹ | 2.3 |
| Comp. Ex. 1 | Cu | 30 | Al₂O₃ | 70 | 12 | | | | 0.076 | 61 | 1.9×10⁶ | Not measurable |
| Comp. Ex. 2 | Cu | 30 | Al₂O₃ | 70 | 13 | | 67 | | 0.076 | 61 | 2.9×10² | 4.3 |
| Comp. Ex. 3 | Cu | 25 | Al₂O₃ | 75 | 13 | 59 | 0.070 | 56 | 9.9×10⁵ | 5.0 | | |
| Comp. Ex. 4 | Cu | 90 | Al₂O₃ | 10 | 12 | | 0.112 | 89 | 2.6×10⁻³ | 0 | | |
| Comp. Ex. 5 | Cu | 100 | - | | 34 | | 0.126 | 100 | 1.8×10⁻⁴ | 0 | | |
| Comp. Ex. 6 | Al | 100 | - | | 30 | | 0.191 | 152 | 1.4×10⁻⁴ | 0 | | |
| Comp. Ex. 7 | Sn | 100 | - | | 17 | | 0.181 | 144 | 1.0×10⁻⁴ | 0 | | |

### <Comparative Measurement of Physical Property Value>

Respective thermal conductivities of the composite fillers according to Examples 1 to 13 and Comparative Examples 1 to 4 and the fillers according to Comparative Examples 5 to 7 were measured using the above-described device. Respective volume resistivities of the composite fillers and the fillers were measured using the high resistance resistivity meter and the powder resistance measurement system for volume resistivities of 10⁶ Ω·cm or more and the low resistance resistivity meter and the powder resistance measurement system for volume resistivities less than 10⁶ Ω·cm. Respective dielectric breakdown voltages of resin molded bodies made using the composite fillers and the fillers by the above-described method were measured using the above-described device. Results of the measurements are illustrated in Table 19. Respective thermal conduction ratios in Examples 1 to 13 and Comparative Examples 1 to 4, 6, and 7 in a case where a thermal conduction ratio of the filler consisting of Cu powder according to Comparative Example 5 was normalized to 100 are also illustrated in Table 19.

### <Assessment>

As can be seen from Tables 18 and 19, since a volume resistivity was measured in a state where powder was compressed under pressure, a seemingly high figure of 1.9×10⁶ Ω·cm was obtained as the volume resistivity of the composite filler according to Comparative Example 1 made using not dry ball mill mixing but hand mixing to mix the core substance and the shell substance. In fact, a shell failed to be formed due to seriously deficient mixing power, a molded body was difficult to make due to very poor affinity for resin, and a dielectric breakdown voltage could not be measured. The composite filler according to Comparative Example 2 made using not dry ball mill mixing but the planetary centrifugal mixer to mix the core substance and the shell substance had a thicker shell substance layer and more voids in a shell than the composite filler according to Example 6 made by mixing in the dry ball mill, and had a volume resistivity as low as 2.9×10² Ω·cm.

In the composite filler according to Comparative Example 3, in which a volume percentage of the core substance and a volume percentage of the shell substance in mixing were 25 vol% and 75 vol%, respectively, and were outside appropriate ranges, the shell substance was too much for the core substance. The composite filler had a dielectric breakdown voltage as high as 5.0 kV/mm, but had a thermal conductivity as low as 0.070 W/m·K. The composite filler according to Comparative Example 4, in which a volume percentage of the core substance and a volume percentage of the shell substance in mixing were 90 vol% and 10 vol%, respectively, and were outside appropriate ranges, had an excellent thermal conductivity as high as 0.112 W/m·K, but the amount of the shell substance was insufficient for appropriate insulation. The composite filler had a volume resistivity as low as 2.6×10⁻³ Ω·cm and a dielectric breakdown voltage as significantly low as 0 kV/mm.

The filler according to Comparative Example 5 consisting of a core substance that is Cu powder as the core substance had an excellent thermal conductivity as high as 0.126 W/m·K, but had a volume resistivity as low as 1.8×10⁻⁴ Ω·cm and a dielectric breakdown voltage as significantly low as 0 kV/mm. The filler according to Comparative Example 6 consisting of a core substance that is Al powder had an excellent thermal conductivity as high as 0.191 W/m·K, but had a volume resistivity as low as 1.4×10⁻⁴ Ω·cm and a dielectric breakdown voltage as significantly low as 0 kV/mm. The filler according to Comparative Example 7 consisting of a core substance that is Sn powder had an excellent thermal conductivity as high as 0.181 W/m·K, but had a volume resistivity as low as 1.0×10⁻⁴ Ω·cm and a dielectric breakdown voltage as significantly low as 0 kV/mm.

In contrast, in each of the composite fillers according to Examples 1 to 13, fumed oxide particles of a shell substance were particles in which perfect sphere primary particles aggregated in the form of strings of beads and fused together to form bulky aggregated particles and the aggregated particles changed into gathered bulk particles, the shell substance and a core substance were mixed in a dry ball mill, and the percentage of the core substance ranged from 30 vol% to 85 vol% and the percentage of the shell substance ranged from 15 vol% to 70 vol% when the percentage of the composite filler was defined as 100 vol%. The composite filler had a thermal conductivity equal to or more than 0.075 W/m·K, a volume resistivity equal to or more than 1.0×10⁵ Ω·cm, and a dielectric breakdown voltage equal to or more than 1 kV/mm.

The composite filler according to Example 6 (the ratio between Cu and fumed alumina particles = 30 vol%:70 vol%) and the composite filler according to Example 9 (the ratio between Cu and fumed alumina particles = 70 vol%:30 vol%) that were identical in materials for a core substance (Cu powder) and a shell substance (fumed alumina particles) but were different in volume percentage were compared in terms of thermal conductivity. While a thermal conductivity in Example 9 rich in core substance was as high as 0.128 W/m·K, a thermal conductivity in Example 6 poor in core substance was as low as 0.086 W/m·K.

In terms of volume resistivity and dielectric breakdown voltage, while a volume resistivity and a dielectric breakdown voltage in Example 6 rich in shell substance were 5.7×10⁵ Ω·cm and 4.6 kV/mm, respectively, a volume resistivity and a dielectric breakdown voltage in Example 9 poor in shell substance were 7.6×10⁶ Ω·cm and 1.2 kV/mm, respectively. Example 9 was higher in volume resistivity than Example 6, and Example 6 was higher in dielectric breakdown voltage than Example 9. This result is not unusual. A volume resistance value of not powder itself but a sample compressed under high pressure is measured, and a voltage of about 0.1 to 0.5 kV at most is applied. As for insulation, use of a dielectric breakdown voltage is more reliable.

Consider Example 10 that subjected, to C4 processing, a composite filler identical in materials for and volume percentages of a core substance and a shell substance to Example 6. Although the thermal conductivity in Example 6 was 0.086 W/m·K, a thermal conductivity in Example 10 was as slightly higher as 0.105 W/m·K. In terms of volume resistivity, the volume resistivity in Example 6 was 5.7×10⁵ Ω·cm, and the volume resistivity in Example 10 was as significantly higher as 1.9×10⁷ Ω·cm. In terms of dielectric breakdown voltage, the dielectric breakdown voltage in Example 6 was 4.6 kV/mm, and a dielectric breakdown voltage in Example 10 was as low as 1.3 kV/mm. This is presumably because air at a core-shell interface and in a shell physical layer was replaced by the C4 processing on the composite filler.

Additionally, the composite filler according to Example 8, in which fumed oxide particles were hydrophobic fumed alumina particles, had a volume resistivity of 3.6×10¹⁰ Ω·cm, and volume resistivities of the composite fillers according to the other examples, in which fumed oxide particles were hydrophilic, were higher. This is presumably because hydrophobic fumed alumina particles have higher volume resistivities than hydrophilic fumed alumina particles.

### {Industrial Applicability}

A composite filler according to the presently disclosed subject matter can be utilized in cooling members for heating elements comprising semiconductor chips, transistors, lithium ion secondary batteries, or LED light sources of communication devices or in-vehicle electronic devices, in cooling members for stators built in housings of motors, in cooling members for power conversion devices built in cases of inverters, or in heat dissipation members for releasing heat generated in sliding portions or rotating portions of actuators, etc.

## Claims

1. A composite filler forming a core-shell structure composed of a core substance made of carbon, metal, zinc oxide or zirconium oxide and a shell substance attached to a surface of the core substance,
wherein the shell substance is formed from fumed oxide particles, the fumed oxide particles being attached to a part or a whole of the surface of the core substance by mixing of the fumed oxide particles and the core substance in a dry ball mill,
the fumed oxide particles are particles changed from bulky aggregated particles to gathered bulk particles, the aggregated particles being formed from perfect sphere primary particles aggregating in a form of strings of beads and fusing together,
percentage of the core substance ranges from 30 vol% to 85 vol% and percentage of the shell substance ranges from 15 vol% to 70 vol% when percentage of the composite filler is defined as 100 vol%,
a thermal conductivity measured using a thermal conductivity measurement device "TRIDENT" (manufactured by C-Therm Technologies Ltd.) and a compression test accessory (CTA) under a maximum compressive load condition (2400.0 gf) is equal to or more than 0.075 W/m·K,
a volume resistivity measured using a high resistance resistivity meter "Hiresta-UX" (manufactured by Mitsubishi Chemical Analytech Co., Ltd.: model number "MCP-HT800") or a low resistance resistivity meter "Loresta-GX" (manufactured by Mitsubishi Chemical Analytech Co., Ltd.: model number "MCP-T700") and a powder resistance measurement system (manufactured by Mitsubishi Chemical Analytech Co., Ltd.: model number "MCP-PD-51") is equal to or more than 1.0×10⁵ Ω·cm, and
a dielectric breakdown voltage measured using an AC withstand voltage tester 7473 (manufactured by Keisoku Giken Co., Ltd.) is equal to or more than 1 kV/mm.

2. The composite filler according to claim 1, wherein the carbon serving as the core substance is black lead, Ketchenblack, graphite, or carbon black, and the metal serving as the core substance is copper, zinc, tin, nickel, aluminum, or stainless steel.

3. The composite filler according to claim 1, wherein a particle diameter of the composite filler is a particle diameter when a volume distribution of the composite filler is measured using a laser diffraction/scattering particle diameter distribution measurement device (manufactured by HORIBA, Ltd.: model "LA960") and ranges from 1 µm to 300 µm.

4. The composite filler according to claim 1, wherein the fumed oxide particles are fumed silica particles or fumed alumina particles.

5. A production method for producing a composite filler, including
mixing of fumed oxide particles and a core substance made of carbon, metal, zinc oxide or zirconium oxide at a volume ratio between the fumed oxide particles and the core substance of 30 to 85:70 to 15 in a dry ball mill, the fumed oxide particles being changed from bulky aggregated particles to gathered bulk particles, the aggregated particles being formed from perfect sphere primary particles aggregating in a form of strings of beads and fusing together to form a core-shell structure in which the fumed oxide particles are attached as a shell substance to a part or a whole of a surface of the core substance,
wherein the fumed oxide particles are particles changed from the bulky aggregated particles to the gathered bulk particles, the aggregated particles being formed from the perfect sphere primary particles aggregating in a form of strings of beads and fusing together to aggregate bulkily.
